# EUROPEAN PATENT APPLICATION

(11) **EP 4 509 949 A1**
(43) Date of publication of application: **19.02.2025**
(21) Application number: 24734783.4
(22) Date of filing: 03.06.2024
(51) Int. Cl.: G06F 1/16, H04M 1/02

(54) **ELECTRONIC DEVICE COMPRISING HINGE APPARATUS**

(30) Priority: 29.06.2023 KR 20230083958; 24.07.2023 KR 20230096243
(71) Applicant: Samsung Electronics Co., Ltd, Suwon-si, Gyeonggi-do 16677 (KR)
(72) Inventor: CHO, Sunggun, Suwon-si, Gyeonggi-do 16677 (KR); CHOI, Jongmin, Suwon-si, Gyeonggi-do 16677 (KR); KIM, Jinwoo, Suwon-si, Gyeonggi-do 16677 (KR); RYU, Myungchul, Suwon-si, Gyeonggi-do 16677 (KR); PARK, Yeongmin, Suwon-si, Gyeonggi-do 16677 (KR); LEE, Dongik, Suwon-si, Gyeonggi-do 16677 (KR); JUNG, Iksu, Suwon-si, Gyeonggi-do 16677 (KR)
(74) Representative: Gulde & Partner
(86) International application number: PCT/KR2024/007536
(87) International publication number: WO 2025/005512

(57) **Abstract**

According to various embodiments, an electronic device may include a first support plate (311) coupled to a hinge device (320, 320-1) in an area corresponding to a first housing (110); a second support plate (312) coupled to the hinge device (320, 320-1) in an area corresponding to the second housing (120); a first rotation member (3217) including a first protrusion (3217a) formed at a position spaced apart from a first rotation axis (X1); a second rotation member (3218) including a second protrusion (3218a) formed at a position spaced apart from a second rotation axis (X2); and a center plate (313) including a first engaging portion (3132a) disposed between the first support plate (311) and the second support plate (312) and interlocked with the first protrusion (3217a) and a second engaging portion (3132b) interlocked with the second protrusion (3217b), wherein the center plate (313) may be moved through interlocking engagement of the first and second protrusions (3217a, 3217b) and the first and second engaging portions (3132a, 3132b) when the foldable housing is moved from the unfolded position to the folded position.

## Description

### [Technical Field]

Embodiments of the disclosure relate to an electronic device including a hinge device.

### [Background Art]

Electronic devices are gradually becoming thinner to meet consumers' purchasing needs as a functional gap between each manufacturer is significantly reduced, and are being improved to increase the rigidity of electronic devices, to strengthen design aspects thereof, and to differentiate functional elements thereof. These electronic devices are gradually being transformed from a uniform rectangular shape into various shapes. For example, the electronic device may have a transformable structure that can utilize a large screen display in the case of being used while being convenient to carry. As a type of such electronic devices, foldable type electronic devices are continuously being released, and operational reliability for frequent folding operations may be required.

The above information may be provided as background art for the purpose of helping understanding of the disclosure. No claim or determination is made as to whether any of the foregoing description may be applied as the prior art related to the disclosure.

### [Disclosure]

### [Technical Problem]

The electronic device may include a foldable electronic device including a first housing and a second housing foldably connected to the first housing through a hinge device (e.g., hinge structure, hinge module, or hinge assembly). The first housing and the second housing are structurally coupled to the hinge device, thereby ensuring operational reliability for a folded state and/or an unfolded state. Such a foldable electronic device may be operated in an in-folding method and/or an out-folding method by rotating the first housing within a range of 0 degrees to 360 degrees with respect to the second housing through the hinge device. The foldable electronic device may include a flexible display disposed across the first housing and the second housing in an unfolded state to 180 degrees.

The foldable electronic device includes a first support plate (e.g., wing plate or hinge plate) and a second support plate disposed in at least a portion of the first housing and the second housing, respectively. The support plates may support the flexible display by being disposed adjacent to each other when the foldable electronic device is in an unfolded state.

However, if the support plates are disposed close to each other, when the electronic device is switched from the folded state to the unfolded state, a rotation radius of the support plates should be considered, and such a rotation radius may make it difficult to secure an efficient disposition space of peripheral structures. In order to secure a disposition space for peripheral structures by reducing the rotation radius of the support plates, the support plates may be spaced apart at regular intervals, and a center plate movably disposed in a vertical direction may be disposed in the hinge housing. The center plate may be disposed to be pressed in a downward direction through at least one spring disposed in the hinge housing, and be moved upward through a structure (e.g., hinge arm) of the hinge device in the folded state.

However, because it is difficult that an operating structure of such a center plate is simultaneously supported by the structure of the hinge device, the operating structure may operate while being tilted to one side by interlocking deviation due to sequential support, or malfunctions may cause due to junction or hooking by peripheral support structures supporting the center plate.

### [Technical Solution]

Various embodiments of the disclosure may provide an electronic device including a hinge device that can help improve operational reliability by inducing a uniform lifting operation of the center plate.

According to various embodiments, an electronic device including a hinge device that can help improve assembly and disposition may be provided by using some components for operating the center plate in combination with the hinge device.

However, the problem to be solved by the disclosure is not limited to the above-described problems, and may be expanded in various ways without departing from the spirit and scope of the disclosure.

According to various embodiments, an electronic device includes a foldable housing including a first housing, a second housing, and at least one hinge device configured to rotatably connect the first housing and the second housing to each other and to operate between a folded position, a partially folded position, and an unfolded position, wherein the at least one hinge device includes a first shaft having a first rotation axis; and a second shaft having a second rotation axis; a first support plate coupled to the at least one hinge device in an area corresponding to the first housing; a second support plate coupled to the at least one hinge device in an area corresponding to the second housing; a first rotation member disposed to rotate with the first shaft and including a first protrusion formed at a position spaced apart from the first rotation axis; a second rotation member disposed to rotate with the second shaft and including a second protrusion formed at a position spaced apart from the second rotation axis; and a center plate including a first engaging portion disposed between the first support plate and the second support plate and interlocked with the first protrusion and a second engaging portion interlocked with the second protrusion, wherein the center plate is configured to move downward from a first position to a second position through interlocking engagement of the first and second protrusions and the first and second engaging portions when the foldable housing is moved from the unfolded position to the folded position, and the center plate is configured to move upward from a second position to a first position through interlocking engagement of the first and second protrusions and the first and second engaging portions when the foldable housing is moved from the folded position to the unfolded position.

According to various embodiments, a foldable electronic device may include a housing including a first housing portion and a second housing portion, a flexible display received in the first housing portion and the second housing portion, and a hinge assembly configured to rotatably connect the first housing portion and the second housing portion to each other, wherein the hinge assembly may include a first shaft configured to rotate based on a first rotation axis while the housing is folded, a second shaft configured to rotate based on a second rotation axis while the housing is folded, a first rotation member including a first protrusion connected to the first shaft so as to rotate with the first shaft and spaced apart from the first rotation axis by a designated distance, a second rotation member including a second protrusion connected to the second shaft so as to rotate with the second shaft and spaced apart from the second rotation axis by a designated distance, and a center plate to which a guide portion including a first opening corresponding to the first protrusion and a second opening corresponding to the second protrusion is connected, wherein the center plate may be moved to a position supporting at least a portion of the flexible display in a fully unfolded state of the foldable electronic device through an interlocking structure of the protrusions and the openings, and the center plate may be moved to a position that does not support at least a portion of the flexible display in a fully folded state of the foldable electronic device through an interlocking structure of the protrusions and the openings.

### [Advantageous Effects]

An electronic device according to embodiments of the disclosure includes a center plate provided between support plates and provided to operate in interlock through a protrusion of a rotation member provided as a component (e.g., washer member) of a hinge device, thereby improving disposition and assembly of the hinge device, and helping improve operational reliability.

Further, various effects directly or indirectly identified through this document can be provided.

Effects obtainable in the disclosure are not limited to the above-described effects, and other effects not described can be clearly understood by those of ordinary skill in the art to which the disclosure belongs from the description below.

### [Description of Drawings]

In relation to the description of the drawings, identical or similar reference numerals may be used for identical or similar components.
FIG. 1A is a front perspective view of an electronic device illustrating a flat state or unfolded state according to various embodiments of the disclosure.
FIG. 1B is a diagram illustrating a front surface of an electronic device in an unfolded state according to various embodiments of the disclosure.
FIG. 1C is a diagram illustrating a rear surface of an electronic device in an unfolded state according to various embodiments of the disclosure.
FIG. 2A is a perspective view of an electronic device illustrating a folded state according to various embodiments of the disclosure.
FIG. 2B is a perspective view of an electronic device illustrating an intermediate state according to various embodiments of the disclosure.
FIG. 3A is a diagram illustrating a constitution of an electronic device including a hinge assembly according to various embodiments of the disclosure.
FIGS. 3B to 3C are exploded perspective views of a hinge assembly viewed from a front surface and a rear surface according to various embodiments of the disclosure.
FIG. 4 is an exploded perspective view of a hinge device according to various embodiments of the disclosure.
FIG. 5 is a coupled perspective view of a hinge assembly according to various embodiments of the disclosure.
FIGS. 6A and 6B are cross-sectional views of an electronic device in an unfolded state and a folded state viewed along line 6-6 of FIG. 5 according to various embodiments of the disclosure.
FIGS. 7A and 7B are cross-sectional views of an electronic device in an unfolded state and a folded state viewed along line 7-7 of FIG. 5 according to various embodiments of the disclosure.
FIGS. 8A and 8B are perspective views of a center plate according to various embodiments of the disclosure.
FIG. 8C is a perspective view of a center plate coupled with a guide damper according to various embodiments of the disclosure.
FIG. 8D is a partial cross-sectional view of the center plate viewed along line 8d-8d of FIG. 8C according to various embodiments of the disclosure.
FIG. 9A is a partial perspective view of a hinge device illustrating a state before coupling of rotation members according to various embodiments of the disclosure.
FIG. 9B is a partial perspective view of a hinge device illustrating a state in which rotation members are coupled according to various embodiments of the disclosure.
FIG. 9C is a diagram illustrating a state in which a center plate is coupled to a hinge device according to various embodiments of the disclosure.
FIGS. 10A to 10C are diagrams illustrating a coupling structure of a guide damper and a hinge device according to various embodiments of the disclosure.
FIG. 11A is a perspective view of a center plate according to various embodiments of the disclosure.
FIG. 11B is a partial cross-sectional view of the center plate viewed along line 11b-11b of FIG. 11A according to various embodiments of the disclosure.
FIG. 11C is a diagram illustrating a state in which a guide damper of FIG. 11A is coupled to a gear support of a hinge device according to various embodiments of the disclosure.
FIGS. 12A to 12D are diagrams illustrating a state in which a center plate is coupled to a gear assembly of a hinge device through a guide damper according to various embodiments of the disclosure.
FIG. 13A is a partial cross-sectional view of an electronic device illustrating an unfolded state according to various embodiments of the disclosure.
FIG. 13B is a diagram of a hinge device illustrating a position of a center plate in the state of FIG. 13A according to various embodiments of the disclosure.
FIG. 13C is a partial cross-sectional view of an electronic device illustrating a folded state according to various embodiments of the disclosure.
FIG. 13D is a diagram of a hinge device illustrating a position of a center plate in the state of FIG. 13C according to various embodiments of the disclosure.
FIG. 14 is a diagram of a portion of a hinge device illustrating the disposition relationship between a protrusion and an opening according to various embodiments of the disclosure.
FIG. 15 is a diagram illustrating a constitution of a hinge assembly according to various embodiments of the disclosure.
FIG. 16A is a diagram illustrating a constitution of a hinge device of FIG. 15 according to various embodiments of the disclosure.
FIGS. 16B and 16C are diagrams illustrating an operation structure of a center plate according to the rotation of a protrusion according to various embodiments of the disclosure.
FIG. 16D is an enlarged view of an area 16d of FIG. 16B according to various embodiments of the disclosure.
FIG. 16E is an enlarged view of an area 16e of FIG. 16C according to various embodiments of the disclosure.
FIG. 16F is a diagram illustrating the positional relationship of cutting portions for assembling a center plate according to various embodiments of the disclosure.
FIG. 16G is a partial perspective view of a shaft according to various embodiments of the disclosure.
FIG. 17 is a diagram illustrating a coupling structure of a guide damper of a center plate and a hinge device according to various embodiments of the disclosure.
FIG. 18A is a diagram illustrating a constitution of a front surface of a hinge assembly according to various embodiments of the disclosure.
FIG. 18B is a diagram illustrating a constitution of a rear surface of a hinge assembly according to various embodiments of the disclosure.
FIGS. 19A and 19B are partial cross-sectional views of a hinge device in a folded state and an unfolded state of an electronic device viewed along line 19-19 of FIG. 18A according to various embodiments of the disclosure.

### [Mode for Disclosure]

Hereinafter, with reference to the drawings, embodiments of the disclosure will be described in detail so that a person skilled in the art to which the disclosure belongs may easily implement the disclosure. However, the disclosure may be implemented in many different forms and is not limited to the embodiments described herein. In relation to the description of drawings, the same or similar reference numerals may be used for the same or similar components. In addition, in the drawings and related descriptions, descriptions of well-known functions and configurations may be omitted for clarity and brevity.

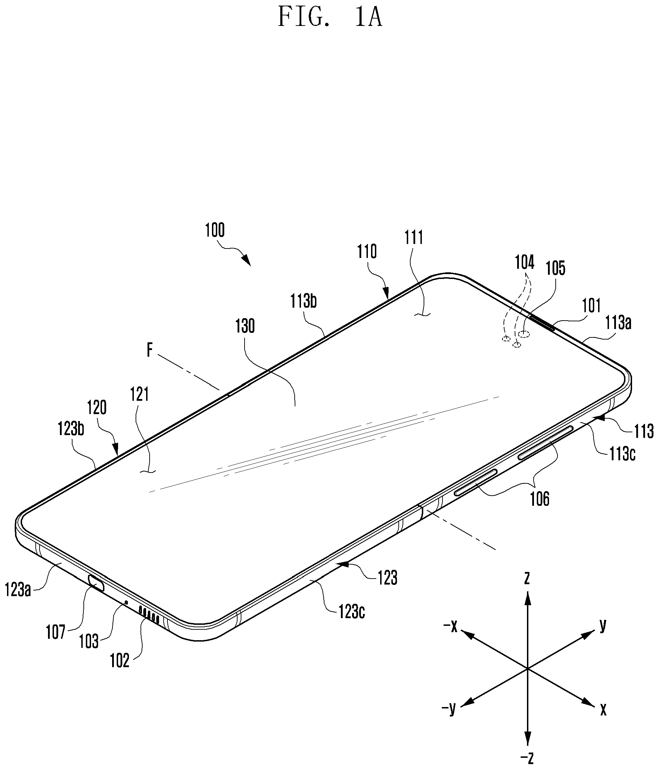

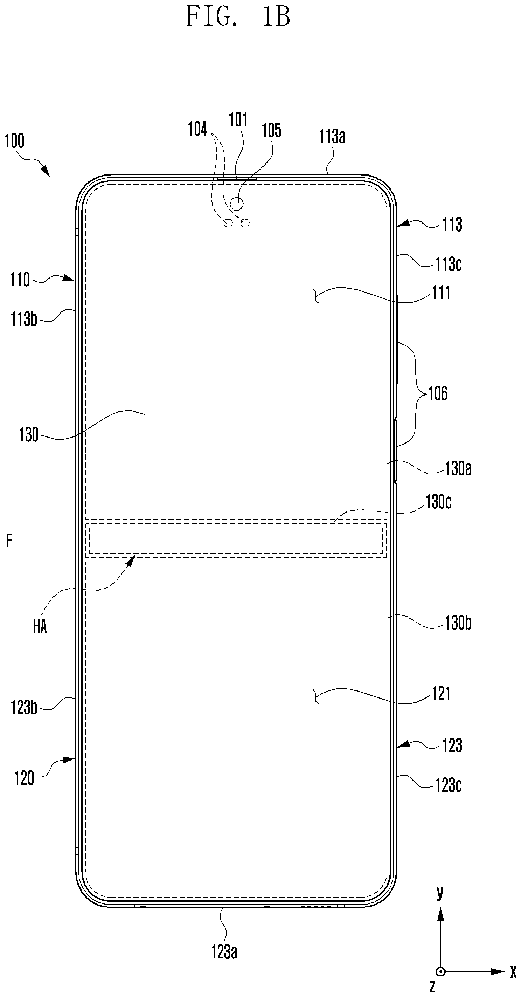

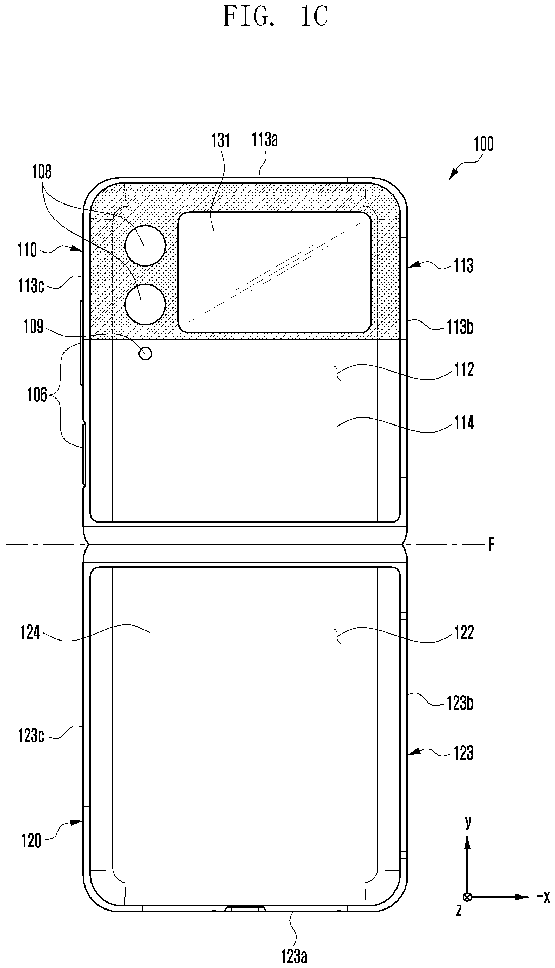

FIG. 1a is a perspective view of an electronic device illustrating a flat state or unfolded state of the electronic device according to various embodiments of the present disclosure. FIG. 1b is a plan view illustrating the front surface of an electronic device in an unfolded state according to various embodiments of the present disclosure. FIG. 1c is a plan view illustrating the rear surface of an electronic device in an unfolded state according to various embodiments of the present disclosure.

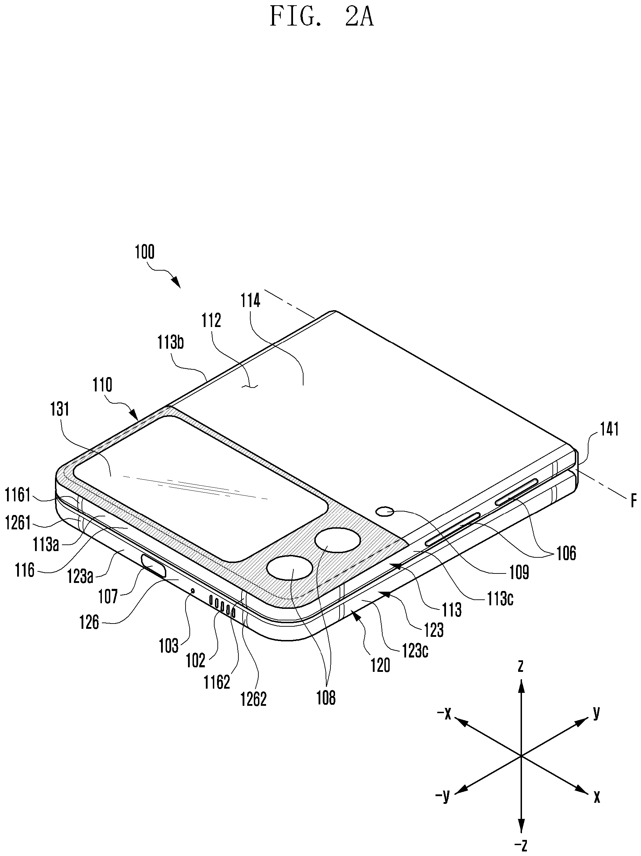

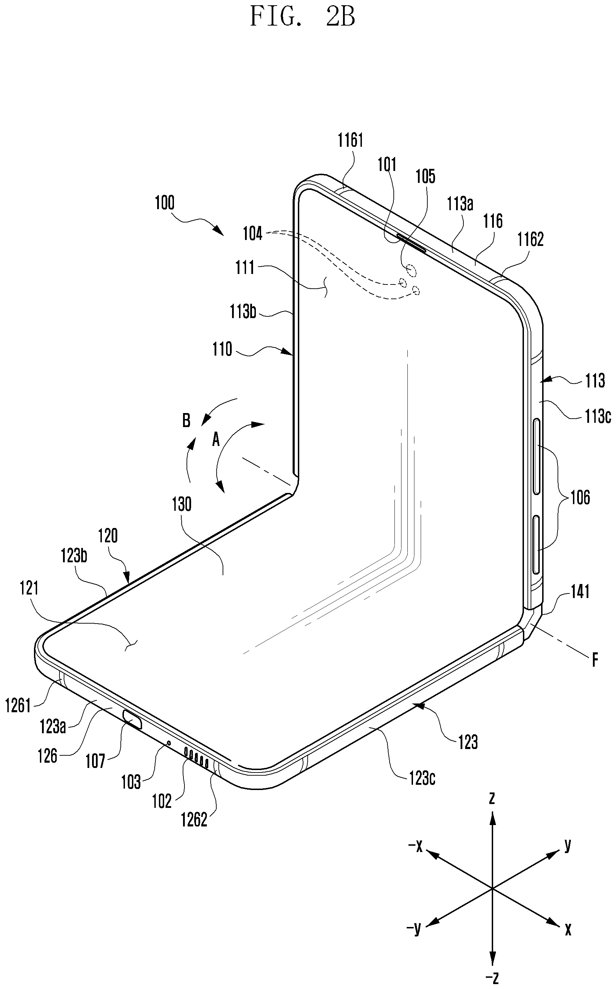

FIG. 2a is a perspective view of an electronic device illustrating a folded state of the electronic device according to various embodiments of the present disclosure. FIG. 2b is a perspective view of an electronic device illustrating an intermediate state of the electronic device according to various embodiments of the present disclosure.

With reference to FIGS. 1a to 2b, the electronic device 100 may include first and second housings 110 and 120 (e.g., a foldable housing structure) that are connected so that they can be folded with respect to each other based on a hinge device (e.g., the hinge device 140 of FIG.1b). In one embodiment, thehinge device (e.g., the hinge device 140 of FIG. 1b) may be disposed in the direction of the X axis or in the direction of the Y axis. In one embodiment, the electronic device 100 may include a first display 130 (e.g., a flexible display, a foldable display, or a main display) disposed in an area (e.g., recess) formed by the first and second housings 110 and 120. In one embodiment, the first housing 110 and the second housing 120 may be disposed on opposite sides centered on the folding axis F and may have a shape that is substantially symmetrical with respect to the folding axis F. In one embodiment, the angle or distance between the first housing 110 and the second housing 120 may vary depending on the state of the electronic device 100. For example, depending on whether the electronic device is in a flat state or an unfolded state, a folded state, or an intermediate state, the first housing 110 and the second housing 120 may have different angles or distances formed from each other.

In one embodiment, the first housing 110 may include a first surface 111 facing the first direction (e.g., the front direction) (z axis direction) and a second surface 112 facing the second direction (i.e., the rear direction) (-z axis direction) opposite the first surface 111 in the unfolded state of the electronic device 100. In one embodiment, the second housing 120, in the unfolded state of electronic device 100, may include a third surface 121 facing the first direction (in the z-axis direction) and a fourth surface 122 facing the second direction (-z axis direction). In one embodiment, in the unfolded state of the electronic device 100, the first surface 111 of the first housing 110 and the third surface 121 of the second housing 120 may face substantially the same first direction (in the direction of the z axis).In one embodiment, in the folded state of the electronic device 100, the first surface 111 of the first housing 110 and the third surface 121 of the second housing 120 may face each other. In one embodiment, in the unfolded state of the electronic device 100, the second surface 112 of the first housing 110 and the fourth surface 122 of the second housing 120 may face substantially the same second direction (- z axis direction). In one embodiment, in the folded state of the electronic device 100, the second surface 112 of the first housing and the fourth surface 122 of the second housing 120 may face opposite each other. For example, in the folded state of electronic device 100, the second surface 112 may face the first direction (in the z axis), and the fourth surface 122 may face the second direction (-z axis direction).In this case, the first display 130 may not be visible from the outside (in folding mode). In one embodiment, the electronic device 100 may be folded so that the second surface 112 of the first housing 110 and the fourth surface 122 of the second housing 120 face each other. In this case, the first display 130 may be disposed to be viewed from the outside (out-folding).

According to various embodiments, the first housing 110 (e.g., the first housing structure) may include a first lateral member 113 that at least partially forms an exterior of the electronic device 100, and a first rear cover 114 that is coupled to the first lateral member 113 and forms at least portion of the second surface 112 of the electronic device 100. In one embodiment, the first lateral member 113 may include the first side surface 113a, the second side surface 113b extending from one end of the first side surface 113a, and the third side surface 113c extending from the other end of the first side surface 113 a. In one embodiment, the first lateral member 113 may be formed into a quadrilateral (e.g., square or rectangular) shape through the first side surface 113a, the second side surface 113b, and the third side surface 113c.

According to various embodiments, the second housing 120 (e.g., the second housing structure) may include a second lateral member 123 that at least partially forms an exterior of the electronic device 100, and a second rear cover 124 that is at least partially coupled to the second lateral member 123, and a second lateral member 123 and forms at least portion of the fourth surface 122 of the electronic device 100. In one embodiment, the second lateral member 123 may include the fourth side surface 123a, the fifth side surface 123b extending from one end of the fourth side surface 123a, and the sixth side surface 123c extending from the other end of the fourth side surface 123a. In one embodiment, the second lateral member 123 may be formed into a quadrilateral shape through the fourth side surface 123a, the fifth side surface 123b, and the sixth side surface 123c.

According to various embodiments, the first and second housings 110, 120 are not limited to the illustrated shape and combination, and may be implemented by a combination and/or a coupling of other shapes or parts. In one embodiment, the first lateral member 113 may be integrally formed with the first rear cover 114, and the second lateral member 123 may be integrally formed with the second rear cover 124.

According to various embodiments, in the unfolded state of the electronic device 100, the second side surface 113b of the first lateral member 113 and the fifth side surface 123b of the second lateral member 123 may be connected without a gap. In one embodiment, in the unfolded state of the electronic device 100, the third side surface 113c of the first lateral member 113 and the sixth side surface 123c of the second lateral member 123 may be connected without a gap. In one embodiment, when electronic device 100 is unfolded, the sum of the lengths of the second side surface 113b and the fifth side surface 123b may be constituted to be longer than the length of the first side surface 113a and/or the fourth side surface 123a. In one embodiment, in the unfolded state of electronic device 100, the sum of the lengths of the third side surface 113c and the sixth side surface 123c may be constituted to be longer than the length of the first side surface 113a and/or the fourth side surface 123a.

With reference to FIG. 2a and FIG. 2b, the first lateral member 113 and/or the second lateral member 123 may contain more polymers formed from or injected into metal. In one embodiment, the first lateral member 113 and/or the second lateral member 123 may also include at least one conductive portion 116 and/or 126 electrically segmented through at least one segmentation portion 1161, 1162 and/or 1261, 1262 formed by the polymer. In such a case, at least one conductive portion 116 and/or 126 may be used as at least portion of an antenna operating in at least one band (e.g., legacy band) specified by an electrical connection with a radio communication circuit contained in electronic device 100.

According to various embodiments, the first rear cover 114 and/or the second rear cover 124 may be formed by a combination of at least one or at least two of the coated or colored glass, ceramics, polymers, or metals (e.g., aluminum, stainless steel (STS), or magnesium).

According to various embodiments, the first display 130 may be disposed to extend from the first surface 111 of the first housing 110 across the hinge device (e.g., the hinge device 140 of FIG. 1b) to at least a portion of the third surface 121 of the second housing 120. In one embodiment, the first display 130 may substantially include a first area 130a corresponding to the first surface 111, a second area 130b corresponding to the second surface 112, and a third area 130c (e.g., a flexible area or folding area) connecting the first area 130a and the second area 130b.In one embodiment, the third area 130c may be disposed in a position corresponding to the hinge device (e.g., the hinge device 140 of FIG. 1b) as part of the first area 130a and/or the second area 130b. In one embodiment, the electronic device 100 may include a hinge housing 141 (e.g., a hinge cover) supporting a hinge device (e.g., the hinge device 140 of FIG. 1b). In one embodiment, the hinge housing 141 may be exposed to the outside when the electronic device 100 is in the folded state, and may be disposed invisibly from the outside by being inserted into the inner space of the first housing 110 and the inner space of the second housing 120when the electronic device 100 is in the unfolded state.

According to various embodiments, electronic device 100 may include a second display 131 (e.g., a subdisplay) that is disposed separately from the first display 130. In one embodiment, the second display 131 may be disposed on the second surface 112 of the first housing 110 to be at least partially exposed. In one embodiment, when the electronic device 100 is in a folded state, the second display 131 may display at least portion of the state information of the electronic device 100, replacing at least portion of the display function of the first display 130. In one embodiment, the second display 131 may be disposed so that it can be viewed from the outside through at least portion of the area of the first rear cover 114.In one embodiment, the second display 131 may be disposed on the fourth surface 122 of the second housing 120. In such a case, the second display 131 may be disposed so that it can be viewed from the outside through at least portion of the area of the second rear cover 124.

According to various embodiments, the electronic device 100 may include at least one of an input device 103 (e.g., microphone), a sound output device 101 and 102, a sensor module 104, a camera device 105 and 108, a keystroke device 106 or a connector port 107. In the illustrated embodiment, the input device 103 (e.g., microphone), the sound output device 101 and 102, the sensor module 104, the camera device 105 and 108, the keystroke device 106 or the connector port 107 are illustrated as holes or circular elements formed in the first housing 110 or second housing 120, but this is illustrative for the purpose of explanation and is not limited thereto. According to various embodiments, input device 103 may include at least one microphone 103 disposed in second housing 120. In one embodiment, input device 103 may include a plurality of microphones 103 that are disposed to detect the direction of sound. In one embodiment, a plurality of microphones 103 may be disposed in appropriate locations in the first housing 110 and/or the second housing 120. In one embodiment, sound output devices 101 and 102 may include at least one speaker 101 and 102.In one embodiment, at least one speaker 101 and 102 may include a call receiver 101 disposed in the first housing 110 and a speaker 102 disposed in the second housing 120. In one embodiment, input device 103, sound output device 101 and 102 and connector port 107 are disposed in a space provided in the first housing 110 and/or second housing 120 of the electronic device 100 and may be exposed to the external environment through at least one hole formed in the first housing 110 and/or second housing 120. In one embodiment, at least one connector port 107 may be used to transmit and receive power and/or data with an external electronic device. In one embodiment, at least one connector port (e.g., an earjack hole) may also accommodate a connector (e.g., an earjack) for transmitting and receiving audio signals with an external electronic device. In one embodiment, holes formed in first housings 110 and/or second housings 120 may be used for input devices 103 and sound outputs 101 and 102. In one embodiment, sound output devices 101 and 102 may also include speakers (e.g., piezo speakers) that are not exposed through holes formed in the first housing 110 and/or second housing 120.

According to various embodiments, the sensor module 104 may generate electrical signals or data values corresponding to the internal operating state of electronic device 100 or external environmental conditions. In one embodiment, the sensor module 104 may detect the external environment through the first surface 111 of the first housing 110. In one embodiment, the electronic device 100 may include at least one additional sensor module that is disposed to detect the external environment through the second surface 112 of the first housing 110. In one embodiment, sensor module 104 (e.g., an illuminance sensor) may be disposed under first display 130 to detect the external environment through first display 130.In one embodiment, the sensor module 104 may include at least one of the following gesture sensors, gyro sensors, barometric pressure sensors, magnetic sensors, acceleration sensors, grip sensors, color sensors, infrared (IR) sensors, biometric sensors, temperature sensors, humidity sensors, ambient light sensors, proximity sensors, biometric sensors, ultrasonic sensors, or ambient light sensors 104.

According to various embodiments, camera devices 105 and 108 may include a first camera device 105 (e.g., a front camera device) disposed on the first surface 111 of the first housing 110 and a second camera device 108 disposed on the second surface 112 of the first housing 110. In one embodiment, electronic device 100 may further include flash 109 disposed near second camera device 108. In one embodiment, camera devices 105 and 108 may include at least one lens, an image sensor, and/or an image signal processor. In one embodiment, camera devices 105 and 108 may be disposed so that two or more lenses (e.g., a wide-angle lens, an ultra-wide-angle lens, or a telephoto lens) and two or more image sensors are located on one surface of the electronic device 100 (e.g., the first surface 111, the second surface 112, the third surface 121), or the fourth surface 122).In one embodiment, the camera devices 105 and 108 may include lenses and/or image sensors for time of flight (TOF).

According to various embodiments, the keystroke device 106 (e.g., a key button) may be disposed on the third side surface 113c of the first lateral member 113 of the first housing 110. In one embodiment, the keystroke device 106 may be disposed on at least one side surface of the other side surfaces 113a and 113b and/or side surfaces 123a, 123b, and 123c of the second housing 120. In one embodiment, the electronic device 100 may not include some or all of the keystroke devices 106 and the non-contained keystroke device 106 may be implemented in another form, such as a soft key, on the first display 130. In one embodiment, the keystroke device 106 may be implemented using a pressure sensor included in first display 130.

According to various embodiments, some of the camera devices 105 and 108 (e.g., the first camera device 105) or sensor module 104 may be disposed to be exposed through the first display 130. In one embodiment, the first camera device 105 or sensor module 104 may be optically exposed to the outside through an opening (e.g., a through hole) formed at least partially on the first display 130 in the inner space of the electronic device 100. In one embodiment, at least portion of the sensor module 104 may be disposed in the inner space of the electronic device 100 so that it is not visually exposed through the first display 130.With reference to FIG. 2b, the electronic device 100 may be operated through a hinge device (e.g., the hinge device 140 of FIG. 1b) to maintain at least one specified folding angle in the intermediate state. In such a case, electronic device 100 may control the first display 130 so that different contents are displayed in the display area corresponding to the first surface 111 and the display area corresponding to the third surface 121.In one embodiment, the electronic device 100 may operate in a substantially unfolded state (e.g., the unfolded state of FIG. 1a) and/or in a substantially folded state (e.g., the folded state of FIG. 2a) with respect to a certain folding angle (e.g., the angle between the first housing 110 and the second housing 120when the electronic device 100 is in an intermediate state) through a hinge device (e.g., the hinge device 140 of FIG. 1b). In one embodiment, the electronic device 100 may be operated through a hinge device (e.g., the hinge device 140 of FIG. 1b) to transition to an unfolded state (e.g., the unfolded state of FIG. 1a) when pressurized force is provided in the unfolding direction (A direction) at a certain folding angle. In one embodiment, the electronic device 100 may be operated through a hinge device (e.g., the hinge device 140 of FIG. 1b) in an unfolded state at a certain folding angle, to transition to a folded state (e.g., a folding state of FIG. 2a) if pressing force is provided in the direction to be folded (B direction). In one embodiment, the electronic device 100 may be operated through a hinge device (e.g., the hinge device 140 of FIG. 1b) to maintain an unfolded state (not shown) at various folding angles (free-stop function).

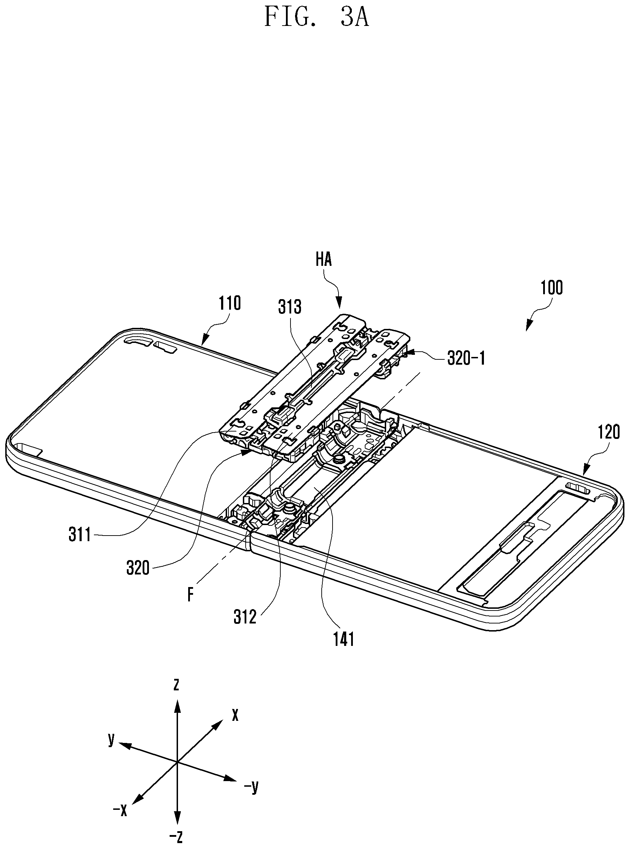

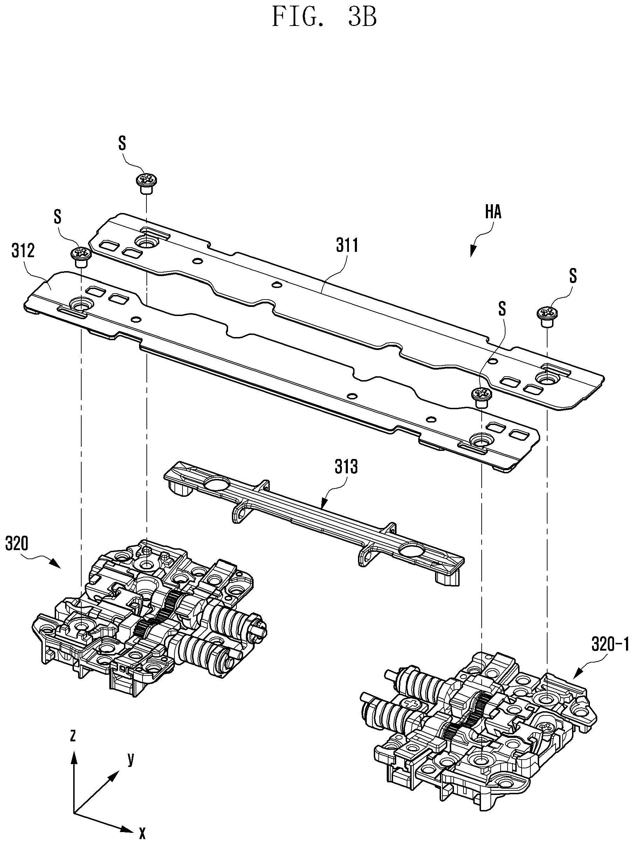

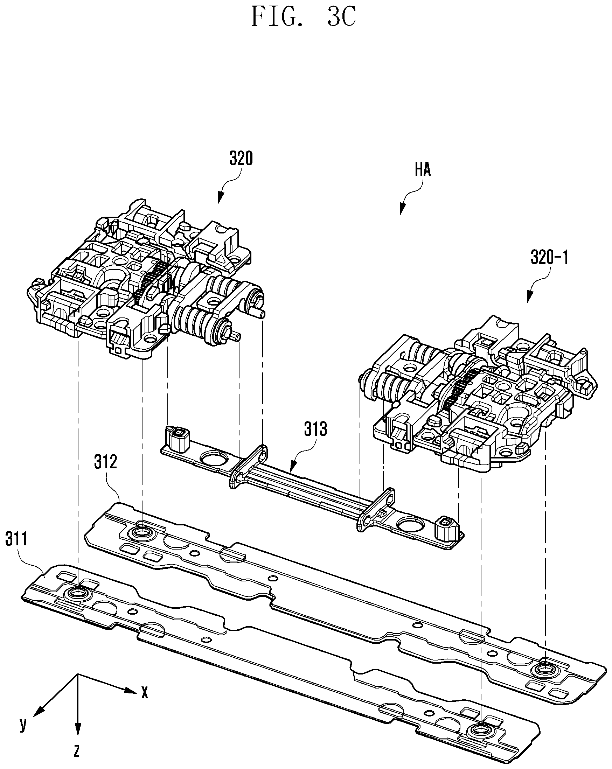

FIG. 3A is a diagram illustrating a constitution of an electronic device including a hinge assembly according to various embodiments of the disclosure. FIGS. 3B to 3C are exploded perspective views of a hinge assembly viewed from a front surface and a rear surface according to various embodiments of the disclosure.

With reference to FIGS. 3A to 3C, the electronic device 100 includes a first housing 110 (e.g., first housing structure), a second housing 120 (e.g., second housing structure) rotatably connected to the first housing 110 through at least one hinge device 320 and 320-1, a first support plate 311 (e.g., first plate, first wing plate, or first hinge plate) disposed to be supported by the at least one hinge device 320 and 320-1, a second support plate 312 (e.g., second plate, second wing plate, or second hinge plate) disposed to be supported by the at least one hinge device 320 and 320-1, a center plate 313 (e.g., third plate, center bar, or auxiliary plate) disposed between the first support plate 311 and the second support plate 312, and a flexible display (e.g., the first display 130 of FIG. 1A) disposed to be supported by the first housing 110, the second housing 120, the first support plate 311, the second support plate 312, and the center plate 313. In an embodiment, at least one hinge device 320 and 320-1, a pair of support plates 311 and 312, and the center plate 313 may be assembled into a hinge assembly HA. In some embodiments, the pair of support plates 311 and 312 and the center plate 313 may be assembled in the at least one hinge device 320 and 320-1 as separate components.

According to various embodiments, the first support plate 311 may form substantially the same plane as that of the first housing 110, and the second support plate 312 may form substantially the same plane as that of the second housing 120. In an embodiment, the center plate 313 may be moved to a second position in order to form the same plane as that of a pair of support plates 311 and 312 through an interlocking structure with at least one hinge device 320 and 320-1 when the electronic device 100 is in an unfolded state. In an embodiment, the center plate 313 may be moved to a second position lower than a first position through an interlocking structure with at least one hinge device 320 and 320-1 when the electronic device 100 is in a folded state. For example, the second position may be relatively closer to a hinge housing 141 than the first position.

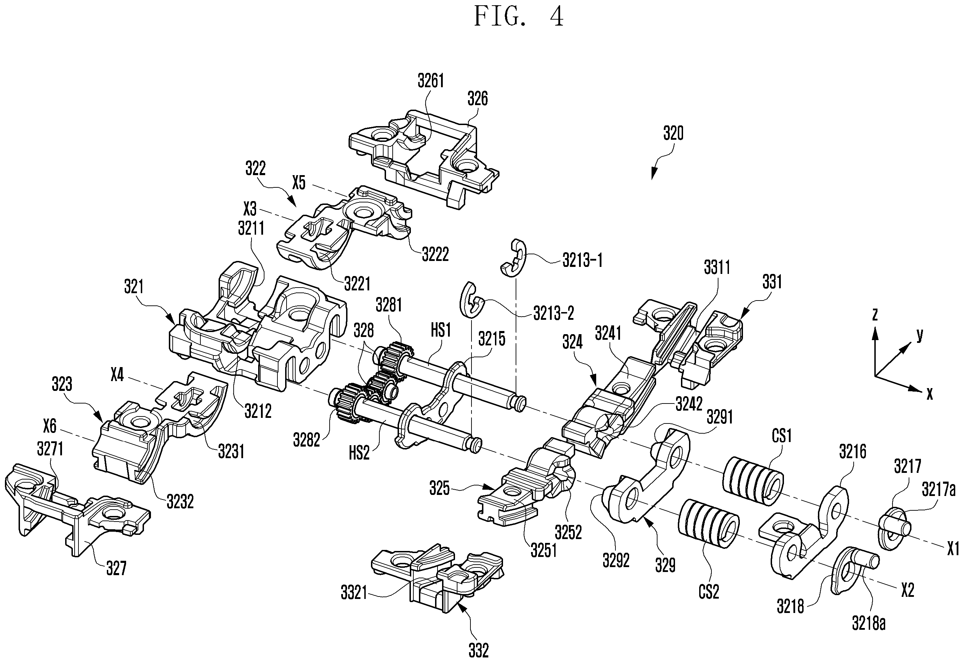

In various embodiments, at least one hinge device 320 and 320-1 may include a first hinge device 320 and a second hinge device 320-1 disposed at both ends of the center plate 313 and the support plates 311 and 312, respectively. In some embodiments, one or three or more of at least one hinge device 320 and 320-1 other than two illustrated hinge devices may be disposed to be spaced apart. In an embodiment, the first housing 110 and the second housing 120 may be rotatably coupled to each other through at least one hinge device 320 and 320-1. For example, the first housing 110 and the second housing 120 may be rotatably connected to each other through some components (e.g., fixed bodies 326 and 327 of FIG. 4) of at least one hinge device 320 and 320-1 and/or links (e.g., links 331 and 332 of FIG. 4). In an embodiment, at least one hinge device 320 and 320-1 may be at least partially fixed to the hinge housing 141. In an embodiment, the first support plate 311 and the second support plate 312 may be fixed to at least one hinge device 320 and 320-1 through a screw S. In an embodiment, the center plate 313 may be coupled to the at least one hinge device 320 and 320-1 to enable a reciprocating movement in a direction (e.g., z-axis direction) perpendicular to a folding axis F.

Hereinafter, in describing the drawings, the first hinge device 320 among the at least one hinge device 320 and 320-1 (e.g., hinge module or hinge structure) has been described, but the second hinge device 320 -1 may also have substantially the same constitution. Further, although an assembly structure and operating structure of the first hinge device 320 and the center plate 313 have been mainly described, an assembly structure and operating structure of the second hinge device 320-1 and the center plate 313 may also have substantially the same constitution.

Further, the meaning of 'center' in the center plate is not a term meaning the center of the electronic device 100, but is used for meaning a plate disposed between the first support plate 311 and the second support plate 312, and this will be understandable to those skilled in the art.

FIG. 4 is an exploded perspective view of a hinge device according to various embodiments of the disclosure.

With reference to FIG. 4, the hinge device 320 may include a support 321 (e.g., rotator bracket or bracket) fixed to a hinge housing (e.g., the hinge housing 141 of FIG. 3A) through a fastening member such as a screw, a first shaft HS1 rotatably disposed in the support 321 based on a first rotation axis X1, a second shaft HS2 rotatably disposed in the support 321 based on a second rotation axis X2 spaced apart from the first rotation axis X1, a first rotator 322 rotatably disposed in the support 321 based on a third rotation axis X3, a second rotator 323 rotatably disposed in the support 321 based on a fourth rotation axis X4, a first fixed body 326 rotatably coupled to the first rotator 322 based on a fifth rotation axis X5, a second fixed body 327 rotatably coupled to the second rotator 323 based on a sixth rotation axis X6, a first hinge arm 324 having one end rotatably coupled to the first shaft HS1 based on the first rotation axis X1, and a second hinge arm 325 having one end rotatably coupled to the second shaft HS2 based on the second rotation axis X2. In an embodiment, the first fixed body 326 may be fixed to the first housing (e.g., the first housing 110 of FIG. 3A). In an embodiment, the second fixed body 327 may be fixed to the second housing (e.g., the second housing 120 of FIG. 3A). In an embodiment, the hinge device 320 may include a first link 331 fixed to the first housing (e.g., the first housing 110 of FIG. 3A) and for movably guiding the other end of the first hinge arm 324 and a second link 332 fixed to the second housing (e.g., the second housing 120 of FIG. 3A) and for movably guiding the other end of the second hinge arm 325. In an embodiment, the first link 331 may be fixed to the first housing (e.g., the first housing 110 of FIG. 3A), and the second link 332 may be fixed to the second housing (e.g., the second housing 120 of FIG. 3A).

According to various embodiments, the first rotator 322 may include a curved first guide slit 3221 formed at one end. In an embodiment, the second rotator 323 may include a curved second guide slit 3231 formed at one end. In an embodiment, the first rotator 322 may include a curved third guide slit 3222 formed at the other end. In an embodiment, the second rotator 323 may include a curved fourth guide slit 3232 formed at the other end. In an embodiment, as a curved first guide rib 3211 formed in the support 321 is coupled to the first guide slit 3221, the first rotator 322 may be rotatably coupled based on the third rotation axis X3. In an embodiment, as a curved second guide rib 3212 formed in the support 321 is coupled to the second guide slit 3231, the second rotator 323 may be rotatably coupled based on the fourth rotation axis X4.

According to various embodiments, as a curved third guide rib 3261 formed in at least a part of the first fixed body 326 is coupled to the third guide slit 3222, the first fixed body 326 may be rotatably coupled based on the fifth rotation axis X5. In an embodiment, as a curved fourth guide rib 3271 formed in at least a part of the second fixed body 327 is coupled to the fourth guide slit 3232, the second fixed body 327 may be rotatably coupled based on the sixth rotation axis X6.

According to various embodiments, the first hinge arm 324 may include a first guide body 3241 movably coupled to a first guide groove 3311 formed in the first link 331 and a first cam element 3242 formed in one side of the first guide body 3241. According to an embodiment, the second hinge arm 325 may include a second guide body 3251 movably coupled to a second guide groove 3321 formed in the second link 332 and a second cam element 3252 formed in one side of the second guide body 3251. In an embodiment, the first hinge arm 324 may induce the first link 331 to move linearly through a straight or curved guide structure of the first guide groove 3311 and the first guide body 3241 or to move rotatably based on another rotation axis. In an embodiment, the second hinge arm 325 may induce the second link 332 to move linearly through a straight or curved guide structure of the second guide groove 3321 and the second guide body 3251 or to move rotatably based on another rotation axis. In an embodiment, the first link 331 may be disposed to at least partially overlap the first fixed body 326. In an embodiment, the second link 332 may be disposed to at least partially overlap the second fixed body 327. In some embodiments, the first link 331 and the second link 332 may be disposed not to overlap the first fixed body 326 and the second fixed body 327, respectively. In some embodiments, the first fixed body 326 and the first link 331 may be integrally formed. In some embodiments, the second fixed body 327 and the second link 332 may be integrally formed.

According to various embodiments, the first shaft HS1 may be rotatably disposed in the support 321 based on the first rotation axis X1 through a gear support 3215 (e.g., gear bracket), and include a first gear 3281. In an embodiment, the first gear 3281 may be disposed in a manner in which the first shaft HS1 penetrates, and rotate with the first shaft HS1 based on the first rotation axis X1. In an embodiment, the second shaft HS2 may be rotatably disposed in the support 321 based on the second rotation axis X2 through the gear support 3215 and include a second gear 3282. In an embodiment, the second gear 3282 may be disposed in a manner in which the second shaft HS2 penetrates, and rotate with the second shaft HS2 based on the second rotation axis X2. In an embodiment, the hinge device 320 may include a pair of idle gears 328 each gear-coupled with the first gear 3281 and the second gear 3282. In some embodiments, the idle gears 328 may be disposed so that an even number of four or more idle gears are gear-coupled. Therefore, when the first fixed body 326 and the first link 331 are unfolded or folded together with the first housing (e.g., the first housing 110 of FIG. 3A), the second fixed body 327 and the second link 332 may be interlocked to unfold or fold together at the same angle together with the second housing (e.g., the second housing 120 of FIG. 3A) through a pair of idle gears 328 gear-coupled with the first gear 3281 and the second gear 3282.

According to various embodiments, the hinge device 320 may include a torque generating structure including a cam structure 329 including a third cam element 3291 cam-coupled with the first cam element 3242 and a fourth cam element 3292 cam-coupled with the second cam element 3252, a shaft support 3216 disposed to support the first shaft HS1 and the second shaft HS2, and a pair of elastic members CS1 and CS2 (e.g., compression coil springor disc spring) disposed in a manner in which the first shaft HS1 and the second shaft HS2 penetrate and for pressing the cam structure 329 in the direction (e.g., -x axis direction) of the hinge arms 324 and 325 based on the shaft support 3216. In an embodiment, the shaft support 3216 may also be disposed in a manner in which the first shaft HS1 and the second shaft HS2 penetrate.

According to various embodiments, the first hinge arm 324 may rotate based on the first rotation axis X1. The first cam element 3242 of the first hinge arm 324, the gear support 3215, the third cam element 3291 of the cam structure 329, the elastic member CS1, and the shaft support 3216 may be aligned through the first shaft HS1 penetrating them. In an embodiment, the second hinge arm 325 may rotate based on the second rotation axis X2. In an embodiment, the second cam element 3252 of the second hinge arm 325, the gear support 3215, the fourth cam element 3292 of the cam structure 329, the elastic member CS2, and the shaft support 3216 may be aligned through the second shaft HS2 penetrating them. In an embodiment, the gear support 3215 may serve as a shaft support supporting the first shaft HS1 and the second shaft HS2. In an embodiment, the first shaft HS1 and the second shaft HS2 may be restrained from being separated through fixing members (e.g., E-rigs) 3213-1 and 3213-2. For example, the fixing members 3213-1 and 3213-2 may include a first fixing member 3213-1 as a first separation prevention part positioned at the end of the first shaft HS1 to prevent separation of a first rotation member 3217 and a second fixing member 3213-2 as a second separation prevention part positioned at the end of the second shaft HS2 to prevent separation of a second rotation member 3218.

According to various embodiments, the cam structure 329 may move in a direction (e.g., -x axis direction) parallel to the first rotation axis X1 and the second rotation axis X2, and the first cam element 3242 of the first hinge arm 424 may be rotatably disposed based on the first rotation axis X1, and the second cam element 3252 of the second hinge arm 325 may be rotatably disposed based on the second rotation axis X2. In an embodiment, when the first cam element 3242 is rotated by the first hinge arm 324 based on the first rotation axis X1, a torque may be generated while the third cam element 3291 cam-coupled and supported by the elastic member CS1 retracts rearward. Likewise, when the second cam element 3252 is rotated by the second hinge arm 325 based on the second rotation axis X2, a torque may be generated while the fourth cam element 3292 cam-coupled and supported by the elastic member CS2 retracts rearward. Accordingly, a torque may be generated while the cam structure 329 retreats rearward due to the retreat of the third cam element 3291 and the fourth cam element 3292. In an embodiment, the magnitude of the torque may be determined according to a shape of the first cam element 3242 and the third cam element 3291 coupled therewith and a shape of the second cam element 3252 and the fourth cam element 3292 coupled therewith, and the first housing (e.g., the first housing 110 of FIG. 3A) and the second housing (e.g., the second housing 120 of FIG. 3A) may be configured to be pressed in an unfolding or folding direction at a designated inflection angle or more by the determined torque or to stop at a designated folding angle.

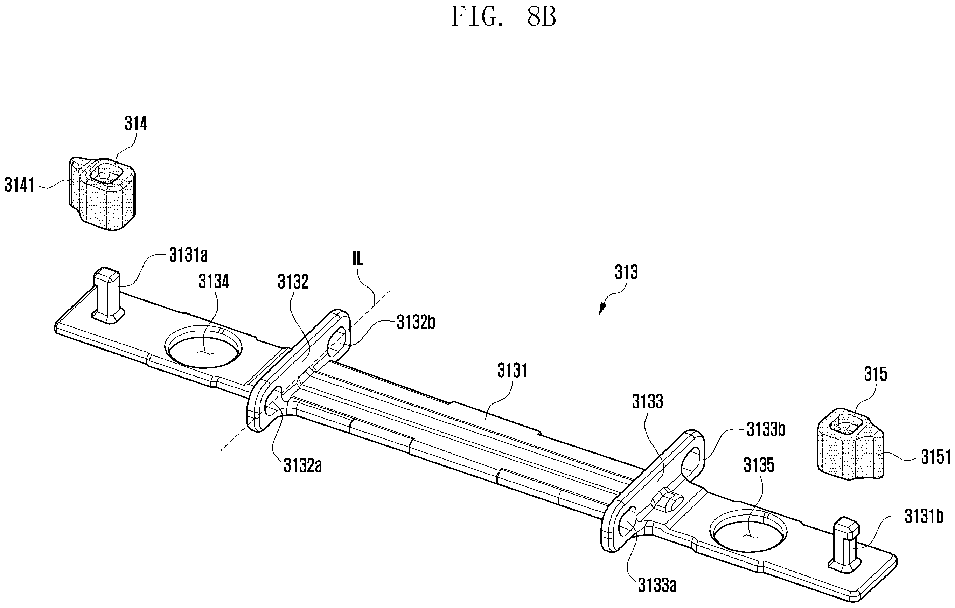

The hinge device 320 according to an exemplary embodiment of the disclosure may include a first rotation member 3217 disposed between the shaft support 3216 and the fixing member 3213-1 in a manner in which the first shaft HS1 penetrates and a second rotation member 3218 disposed between the shaft support 3216 and the fixing member 3213-2 in a manner in which the second shaft HS2 penetrates. In an embodiment, the first rotation member 3217 may be coupled to rotate with the first shaft HS1. In an embodiment, the second rotation member 3218 may be coupled to rotate with the second shaft HS2. In an embodiment, the first rotation member 3217 may include a first protrusion 3217a protruded outward to perform a circular motion based on the first rotation axis X1 at a position spaced apart from the first rotation axis X1. In an embodiment, the second rotation member 3218 may include a second protrusion 3218a protruded outward to perform a circular motion based on the second rotation axis X2 at a position spaced apart from the second rotation axis X2. In an embodiment, as the first protrusion 3217a and the second protrusion 3218a are disposed to interlock with openings (e.g., openings 3132a and 3132b of FIG. 8B) of a center plate (e.g., a center plate 313 of FIG. 8B) to be described later, the center plate 313 may be induced to move linearly in the vertical direction (e.g., ±z axis direction) by a circular motion of the first protrusion 3217a and the second protrusion 3218a. In an embodiment, the first rotation member 3217 and the second rotation member 3218 may indirectly transmit a pressing force provided by the elastic member CS between the shaft support 3216 and the fixing member 3213 to the fixing member 3213, thereby being used as a washer member for preventing separation of the fixing member 3213 by direct transmission of a pressing force. In an embodiment, the first rotation member 3217 and/or the second rotation member 3218 are generally formed in a circular shape, but are not limited thereto. When an installation space is allowed, the first rotation member 3217 and/or the second rotation member 3218 may be formed in various shapes such as a circle, oval, square, or polygon (e.g., triangle, pentagon, and hexagon). In some embodiments, the first rotation member 3217 and the second rotation member 3218 may have the same shape or different shapes.

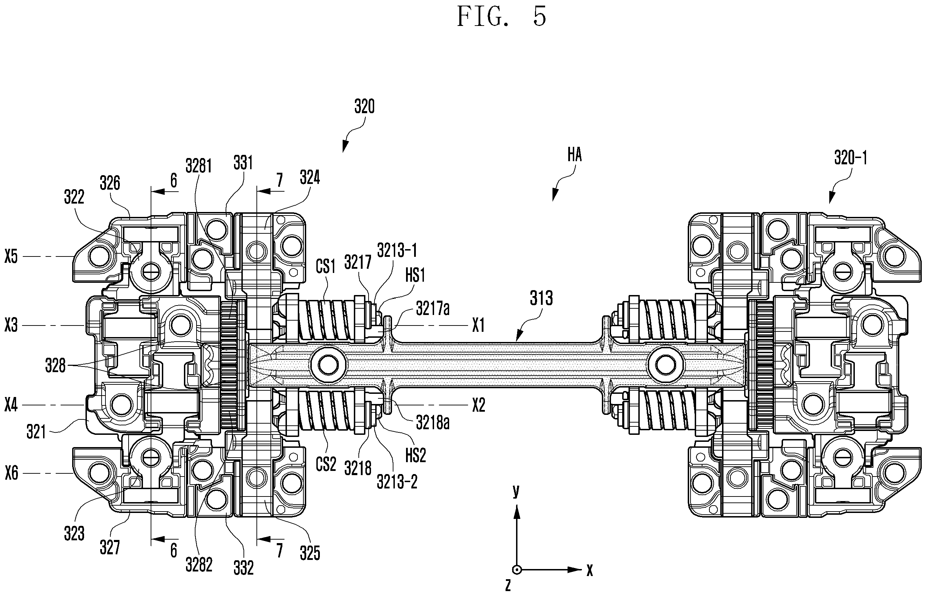

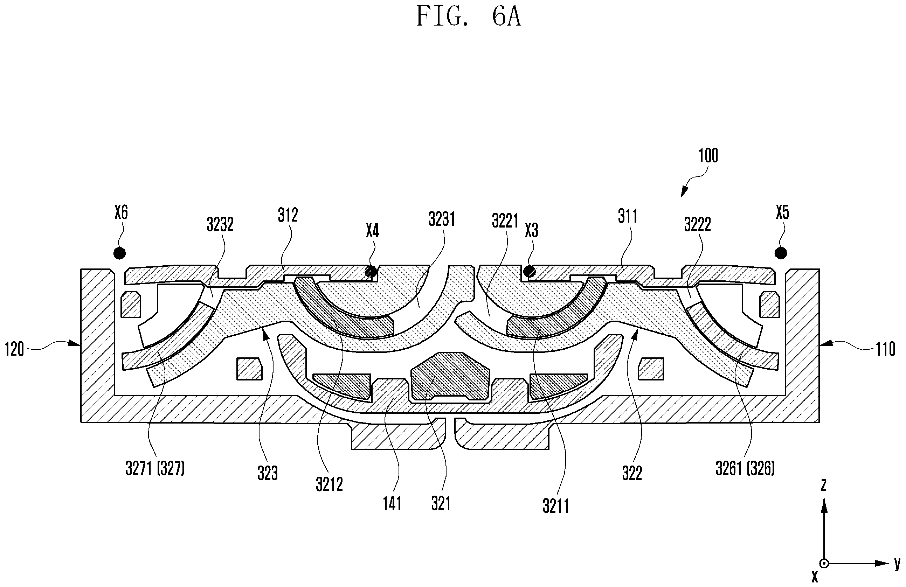

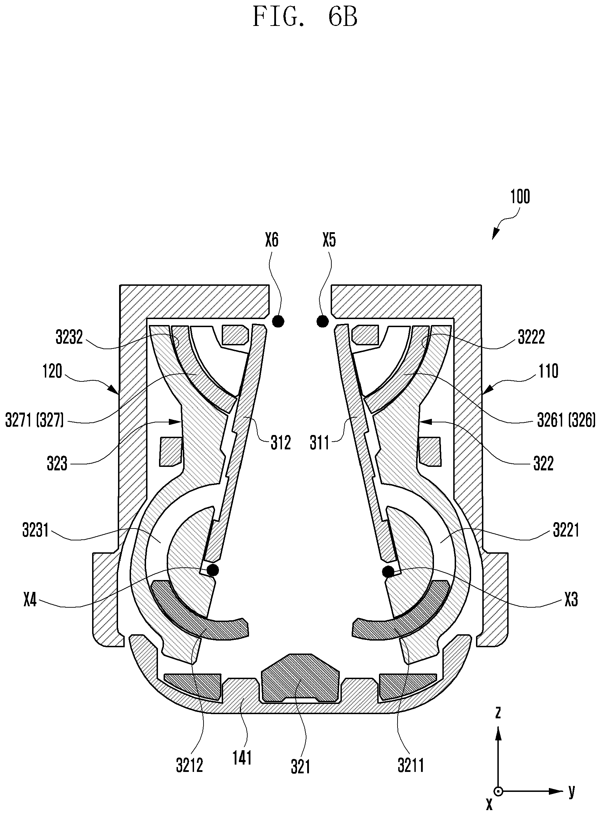

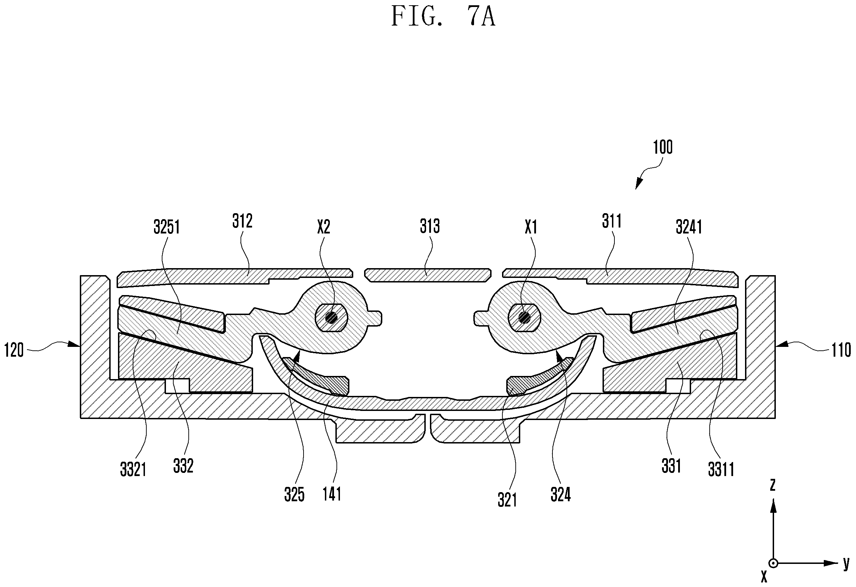

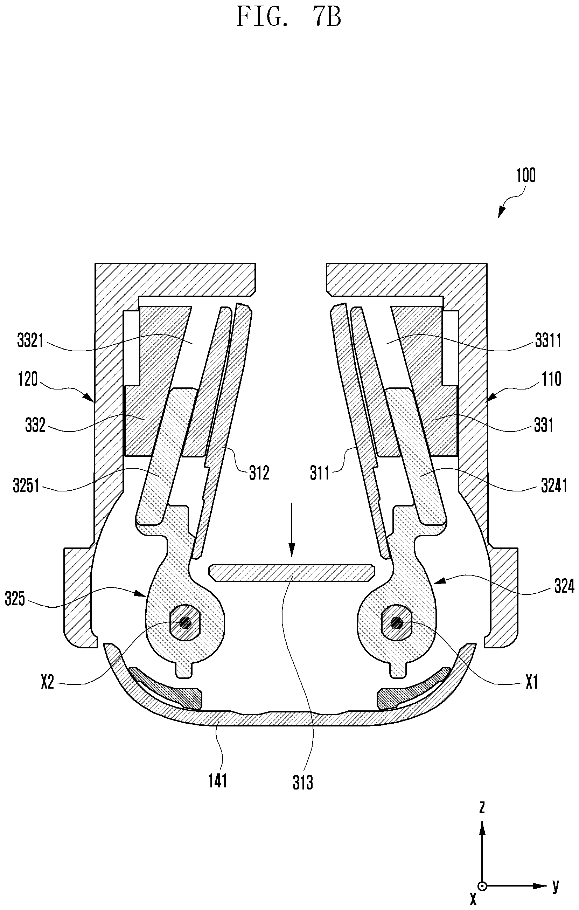

FIG. 5 is a coupled perspective view of a hinge assembly according to various embodiments of the disclosure. FIGS. 6A and 6B are cross-sectional views of an electronic device in an unfolded state and a folded state viewed along line 6-6 of FIG. 5 according to various embodiments of the disclosure. FIGS. 7A and 7B are cross-sectional views of an electronic device in an unfolded state and a folded state viewed along line 7-7 of FIG. 5 according to various embodiments of the disclosure.

With reference to FIGS. 5 to 7B, at least one hinge device 320 and 320-1 may be disposed to support the first support plate 311 and the second support plate 312 and the center plate 313 disposed in an upper portion thereof. In an embodiment, the first support plate 311 may be fixed to the first rotator 322 through a fastening member (e.g., screw). In an embodiment, the second support plate 312 may be fixed to the second rotator 323 through a fastening member. In an embodiment, the center plate 313 may be disposed between the first support plate 311 and the second support plate 312. In an embodiment, the center plate 313 may be disposed movably in a vertical direction (e.g., ±z axis direction) in at least one hinge device 320 and 320-1.

According to various embodiments, the first shaft HS1 may be rotatably disposed in the support 321 based on the first rotation axis X1. In an embodiment, the second shaft HS2 may be rotatably disposed in the support 321 based on the second rotation axis X2. In an embodiment, as the curved first guide rib 3211 formed in the support 321 is coupled to the first guide slit 3221, the first rotator 322 may be rotably coupled based on the third rotation axis X3. In an embodiment, as the curved second guide rib 3212 formed in the support 321 is coupled to the second guide slit 3231, the second rotator 323 may be rotably coupled based on the fourth rotation axis X4. In an embodiment, as the curved third guide rib 3261 formed in at least a part of the first fixed body 326 is coupled to the third guide slit 3222, the first fixed body 326 may be rotatably coupled based on the fifth rotation axis X5. In an embodiment, as the curved fourth guide rib 3271 formed in at least a part of the second fixed body 327 is coupled to the fourth guide slit 3232, the second fixed body 327 may be rotatably coupled based on the sixth rotation axis X6. In an embodiment, the first hinge arm 324 may be disposed to rotate based on the first rotation axis as the first shaft penetrates the first hinge arm 324. In an embodiment, the second hinge arm 325 may be disposed to rotate based on the second rotation axis as the second shaft penetrates the second hinge arm 325. As the first gear 3281 fixed to the first shaft HS1 and the second gear 3282 fixed to the second shaft HS2 are gear-coupled with the idle gears 328 disposed therebetween, the first hinge arm 324 and the second hinge arm 325 may be induced to rotate at the same angle.

According to various embodiments, the first support plate 311 may be induced to rotate at an angle greater than a folding angle (e.g., 90 degrees) of the first housing 110 through a rotation coupling structure of the first rotator 322 rotating based on the third rotation axis X3, a rotation coupling structure of the first fixed body 326 rotating based on the fifth rotation axis X5, and a coupling structure of the first hinge arm 324 having one end rotating based on the first rotation axis X1 together with the first shaft HS1 and the other end guided through the first link 331. In an embodiment, the second support plate 312 may be induced to rotate at an angle greater than a folding angle (e.g., 90 degrees) of the second housing 120 through a rotation coupling structure of the second rotator 323 rotating based on the fourth rotation axis X4, a rotation coupling structure of the second fixed body 327 rotating based on the sixth rotation axis X6, and a coupling structure of the second hinge arm 325 having one end rotating based on the second rotation axis X2 together with the second shaft HS2 and the other end guided through the second link 332. Accordingly, through the rotation structure of each component described above, a bending area of the flexible display (e.g., the flexible display 130 of FIG. 1A) may be folded into a waterdrop shape. In some embodiments, the flexible display 130 may be folded to have a 'U' shape through the rotational structure of each component described above.

According to an exemplary embodiment of the disclosure, the center plate 313 is moved into a first position so as to form the same plane as that of the first support plate 311 and the second support plate 312 in an unfolded state of the electronic device 100, thereby smoothly supporting the flexible display 130. In an embodiment, the center plate 313 is moved to the second position in the direction (e.g., -z axis direction) of the hinge housing 141 in a folded state of the electronic device 100, thereby being in contact with or close to the flexible display 130 under a bending area of the flexible display 130. For example, in a fully folded state of the electronic device 100, the center plate 313 may be moved to a position that does not support at least a portion of the flexible display 130 through an interlocking structure of protrusions (e.g., the protrusions 3217a and 3218a of FIG. 4) and openings (e.g., openings 3132a and 3132b of FIG. 8B) formed in the center plate 313. For example, in the folded state of the electronic device 100, a contact area between the center plate 313 and the flexible display 130 may be smaller than that between the center plate 313 and the flexible display 130 in the unfolded state of the electronic device 100. In an embodiment, the center plate 313 may be disposed to move in the vertical direction through a rotation of the first rotation member 3217 and the second rotation member 3218 applied as some components of the hinge device 320, thereby helping improve operational reliability.

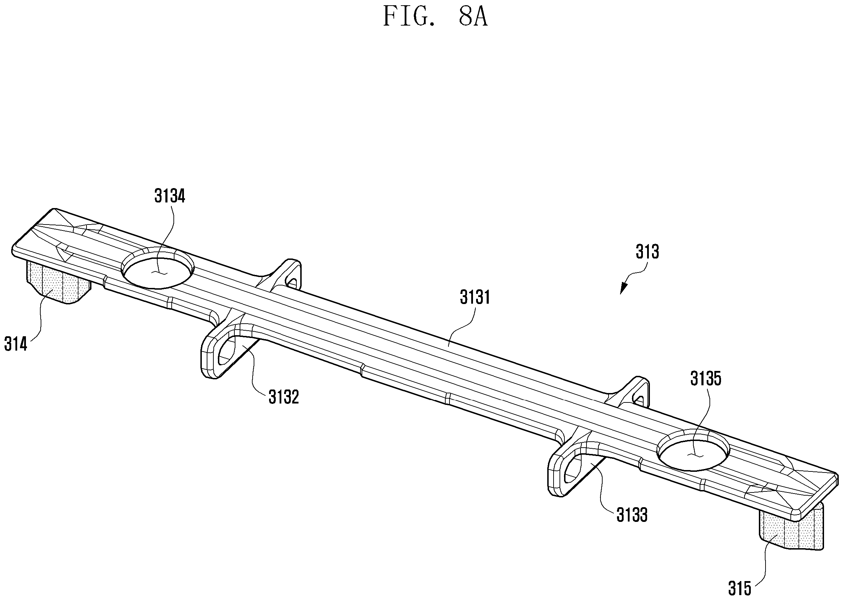

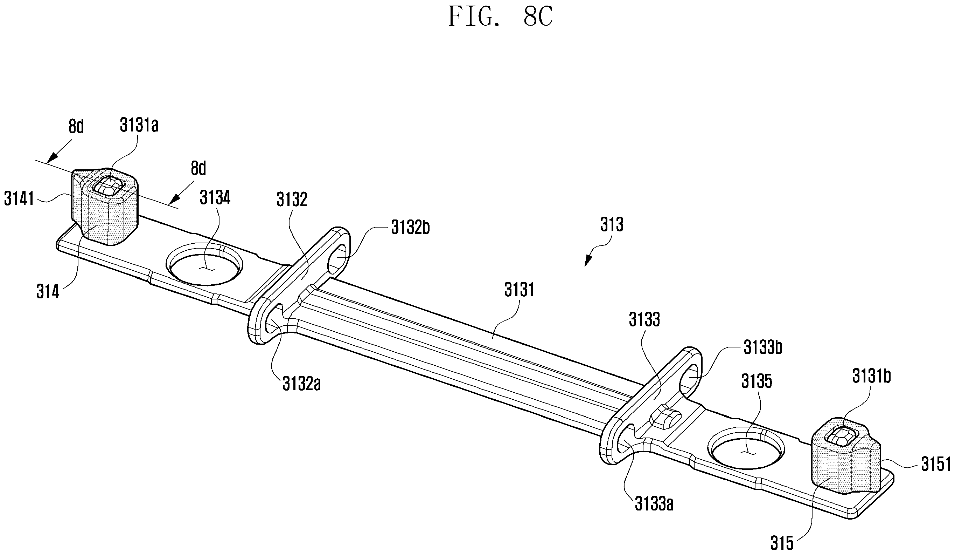

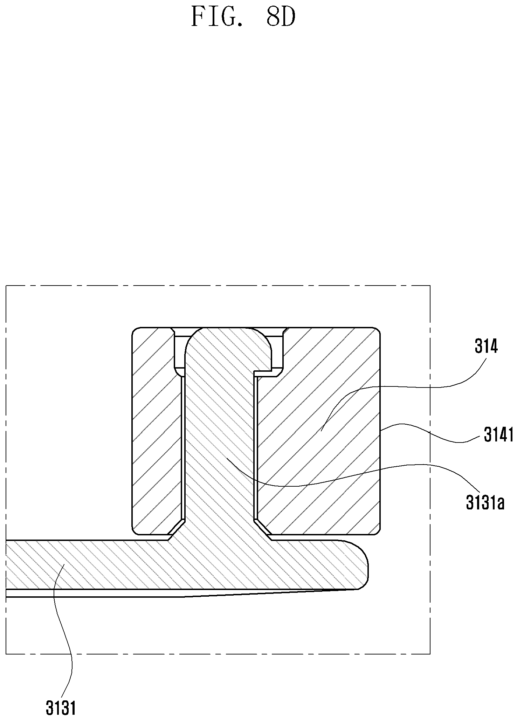

FIGS. 8A and 8B are perspective views of a center plate according to various embodiments of the disclosure. FIG. 8C is a perspective view of a center plate coupled with a guide damper according to various embodiments of the disclosure. FIG. 8D is a partial cross-sectional view of the center plate viewed along line 8d-8d of FIG. 8C according to various embodiments of the disclosure.

With reference to FIGS. 8A to 8D, the center plate 313 may include a plate portion 3131 having a length, at least one guide portion 3132 and 3133 extended from the plate portion 3131, and at least one guide damper 314 and 315 protruded from the plate portion 3131. For example, at least one guide portion 3132 and 3133 may include a first guide portion 3132 formed as a first bent region disposed at one end of the center plate 313 and a second guide portion 3133 formed as a second bent region disposed at the other end of the center plate 313. In an embodiment, the plate portion 3131 may be formed to have a length extended from a first hinge device (e.g., the first hinge device 320 of FIG. 5) to a second hinge device (e.g., the second hinge device 320-1 of FIG. 5). In an embodiment, at least one guide portion 3132 and 3133 may include a first guide portion 3132 coupled to the first hinge device 320 and a second guide portion 3133 coupled to the second hinge device 320-1. In an embodiment, the first guide portion 3132 may include a first opening 3132a as a first engaging portion through which a first protrusion (e.g., the first protrusion 3217a of FIG. 4) of the first rotation member (e.g., the first rotation member 3217 of FIG. 4) may penetrate and a second opening 3132b as a second engaging portion through which a second protrusion (e.g., the second protrusion 3218a of FIG. 4) of the second rotation member (e.g., the second rotation member 3218 of FIG. 4) may penetrate. In an embodiment, the first opening 3132a may be formed to have a size larger than the cross-sectional area of the first protrusion 3217a. In an embodiment, the second opening 3132b may be formed to have a size larger than the cross-sectional area of the second protrusion 3218a. In an embodiment, the second guide portion 3133 may also include a third opening 3133a and a fourth opening 3133b formed in substantially the same manner as the first guide portion 3132. In an embodiment, the plate portion 3131 may include a fifth opening 3134 and a sixth opening 3135. For example, the shaft support (e.g., the shaft support 3216 of FIG. 4) may be fixed to the hinge housing 141 (e.g., screw) through a fastening member (e.g., screw) penetrated in the fifth opening 3134 and/or the sixth opening 3135.

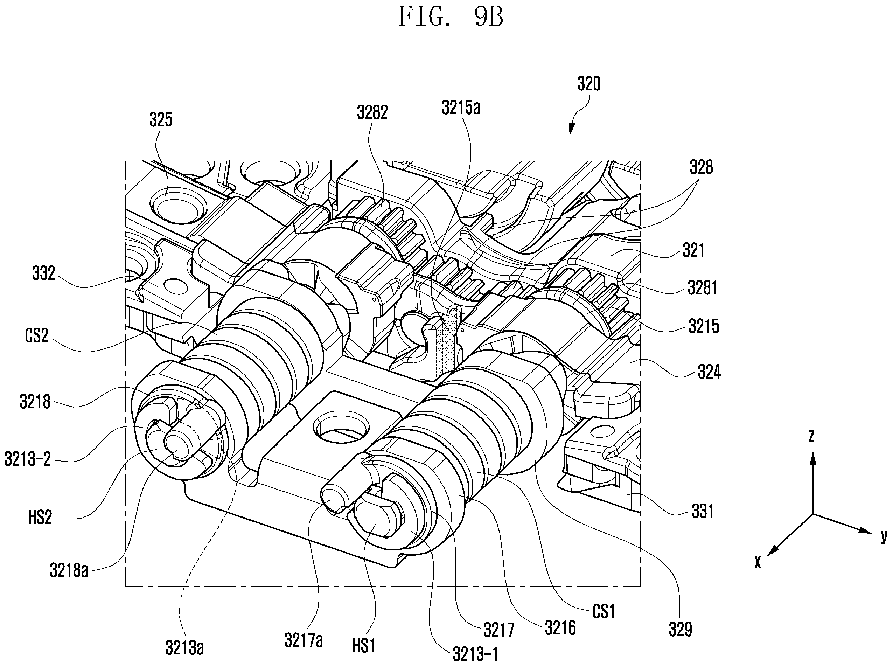

According to various embodiments, at least one guide damper 314 and 315 may include a first guide damper 314 disposed between one end of the plate portion 3131 and the first guide portion 3132 in the center plate 313 and a second guide damper 315 disposed between the other end of the plate portion 3131 and the second guide portion 3133. In an embodiment, the first guide damper 314 may be disposed in a manner in which the first mounting protrusion 3131a protruded from the center plate 313 is inserted into a portion of the first guide damper 314. In an embodiment, the end portion of a first mounting protrusion 3131a is formed in a hook structure, thereby preventing the guide damper 314 from being spaced apart from the first mounting protrusion 3131a. In an embodiment, the first guide damper 314 may include a protruding portion 3141 protruded to be guided to a guide slit (e.g., a guide slit 3215a of FIG. 9B) formed in the gear support (e.g., a gear support 3215 of FIG. 9B) of the first hinge device (e.g., a hinge device 320 of FIG. 9B). In an embodiment, the center plate 313 and the first mounting protrusion 3131a may be made of a metal or polymer. In an embodiment, the first guide damper 314 may be made of an elastic material. For example, the first guide damper 314 may be made of an elastic material such as rubber, urethane foam, or silicon. In some embodiments, the first guide damper 314 may include a coating layer for reducing a friction force so as to induce a smooth sliding operation of the protruding portion 3141 and the guide slit 3215a. In an embodiment, the coating layer may include a Teflon coating layer or a hard coating layer. In an embodiment, the second guide damper 315 having the protruding portion 3151 may also be fixed to the center plate in substantially the same manner as that of the first guide damper 314. In some embodiments, the center plate 313 may include an injection molded product of an elastic material injected to serve as a guide damper in the mounting protrusions 3131a and 3131b without the guide dampers 314 and 315.

The guide dampers 314 and 315 according to exemplary embodiments of the disclosure may improve operational reliability by alleviating impacts that can occur with the hinge devices 320 and 320-1 according to the left and right movements of the center plate 313 during operation while smoothly guiding the center plate 313 in a vertical direction (e.g., ±z axis direction of FIG. 5) according to an unfolding and folding operation of the electronic device.

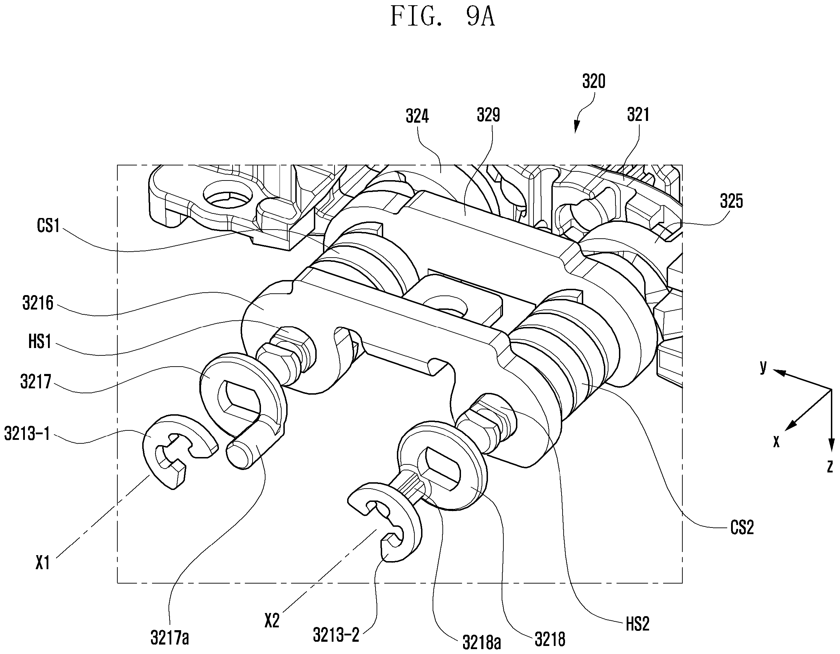

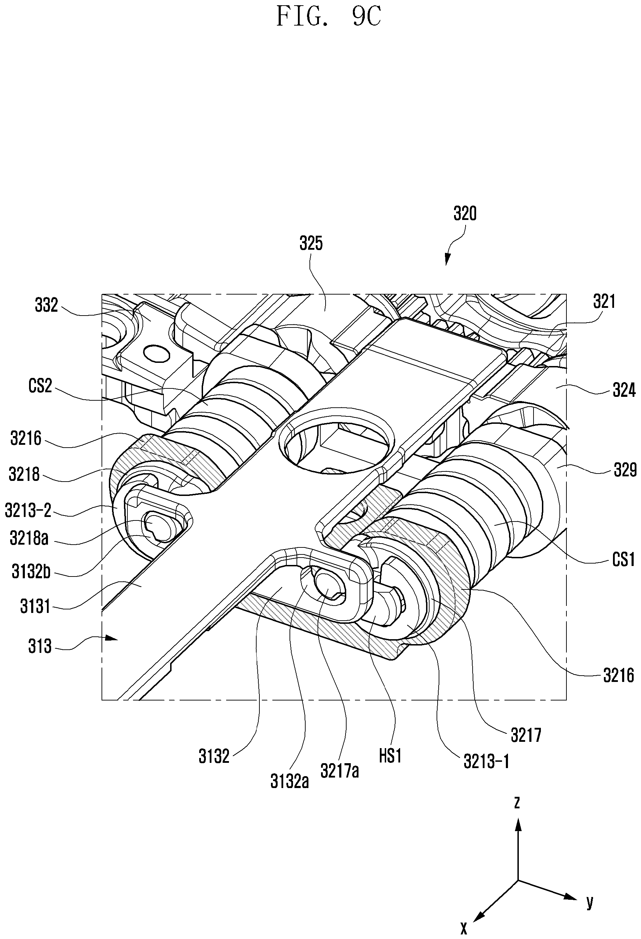

FIG. 9A is a partial perspective view of a hinge device illustrating a state before coupling of rotation members according to various embodiments of the disclosure. FIG. 9B is a partial perspective view of a hinge device illustrating a state in which rotation members are coupled according to various embodiments of the disclosure. FIG. 9C is a diagram illustrating a state in which a center plate is coupled to a hinge device according to various embodiments of the disclosure.

With reference to FIGS. 9A to 9C, the hinge device 320 may include a first shaft HS1 rotatably coupled to the support 321 based on the first rotation axis X1 and a second shaft HS2 rotatably coupled to the support 321 based on the second rotation axis X2. In an embodiment, the hinge device 320 may include a first gear 3281 disposed in a manner in which the first shaft HS1 penetrates, a second gear 3282 disposed in a manner in which the second shaft HS2 penetrates, and a pair of idle gears 328 disposed between the first gear 3281 and the second gear 3282 and gear-coupled with the first gear 3281 and the second gear 3282. In an embodiment, the hinge device 320 may include a gear support 3215 for supporting the first gear 3281 and the second gear 3282 and the idle gears 328 in a manner in which the first shaft HS1 and the second shaft HS2 penetrate simultaneously. In an embodiment, the gear support 3215 may include a guide slit 3215a in which the protruding portion 3141 of the guide damper 314 disposed in the center plate 313 is received and then guided.

According to various embodiments, the hinge device 320 may include a first hinge arm 324 rotatably coupled based on the first rotation axis X1 in a manner in which the first rotation axis HS1 penetrates and a second hinge arm 325 rotatably coupled based on the second rotation axis X2 in a manner in which the second rotation axis HS2 penetrates. In an embodiment, the hinge device 320 may include a cam structure 329, elastic members CS1 and CS2, and a shaft support 3216 sequentially disposed from the hinge arms 324 and 325 in the end direction (e.g., x-axis direction) of the shafts HS1 and HS2. In an embodiment, the cam structure 329, the elastic members CS1 and CS2, and the shaft support 3216 may be disposed in a manner in which the first shaft HS1 and the second shaft HS2 penetrate. In an embodiment, the first hinge arm 324, the cam structure 329, the elastic member CS1, and the shaft support 3216 may be aligned through the first shaft HS1 penetrating them. In an embodiment, the second hinge arm 325, the cam structure 329, the elastic member CS2, and the shaft support 3216 may be aligned through the second shaft HS2 penetrating them. In an embodiment, the first shaft HS1 and the second shaft HS2 penetrating the shaft support 3216 may be restrained from being separated through fixing members (e.g., E-rigs) 3213-1 and 3213-2.

According to various embodiments, the hinge device 320 may include a first rotation member 3217 disposed between the shaft support 3216 and the fixing member 3213-1 in a manner in which the first shaft HS1 penetrates and a second rotation member 3218 disposed between the shaft support 3216 and the fixing member 3213-2 in a manner in which the second shaft HS2 penetrates. In an embodiment, the first rotation member 3217 may be coupled to rotate with the first shaft HS1. In an embodiment, the second rotation member 3218 may be coupled to rotate with the second shaft HS2. In an embodiment, the first rotation member 3217 may include a first protrusion 3217a protruded outward to perform a circular motion based on the first rotation axis X1 at a position spaced apart from the first rotation axis X1. In an embodiment, the second rotation member 3218 may include a second protrusion 3218a protruded outward to perform a circular motion based on the second rotation axis X2 at a position spaced apart from the second rotation axis X2. In an embodiment, the first protrusion 3217a may be disposed to interlock with the first opening 3132a of the guide portion 3132 extended from the plate portion 3131 of the center plate 313. In an embodiment, the second protrusion 3218a may be disposed to interlock with the second opening 3132b of the guide portion 3132. For example, the guide portion 3132 may be positioned along a direction perpendicular to the surface of the plate portion 3131, the upper end of the guide portion 3132 may be positioned generally at the same plane as that of the upper surface of the plate portion 3131, and the lower end of the guide portion 3132 may be positioned to generally protrude further than the rear surface of the plate portion 3131. For example, the guide portion 3132 may be formed so that an imaginary line IL connecting the center of the first opening 3132a and the center of the second opening 3132b is positioned under the plate portion 3131. Accordingly, the center plate 313 may be induced to move linearly in the vertical direction (e.g., ±z-axis direction) by a circular motion of the first protrusion 3217a and the second protrusion 3218a. For example, the first protrusion 3217a may move in contact with an upper surface of the first opening 3132a while the electronic device 100 is folded, and the second protrusion 3218a may move in contact with an upper surface of the second opening 3132b while the electronic device 100 is folded. For example, the first protrusion 3217a may move in contact with a lower surface of the first opening 3132a while the electronic device 100 is unfolded, and the second protrusion 3218a may move in contact with a lower surface of the second opening 3132b while the electronic device 100 is unfolded. In an embodiment, the first rotation member 3217 and the second rotation member 3218 may indirectly transmit a pressing force provided by the elastic member CS between the shaft support 3216 and the fixing member 3213 to the fixing member 3213, thereby being used as a washer member for preventing separation of the fixing member 3213 due to direct transmission of a pressing force. In an embodiment, in the case that the fixing member 3213 includes an E-ring, the protrusion is aligned to protrude through an open area 3213a of the E-ring, thereby increasing efficiency of disposition of the protrusion according to coupling of the E-ring.

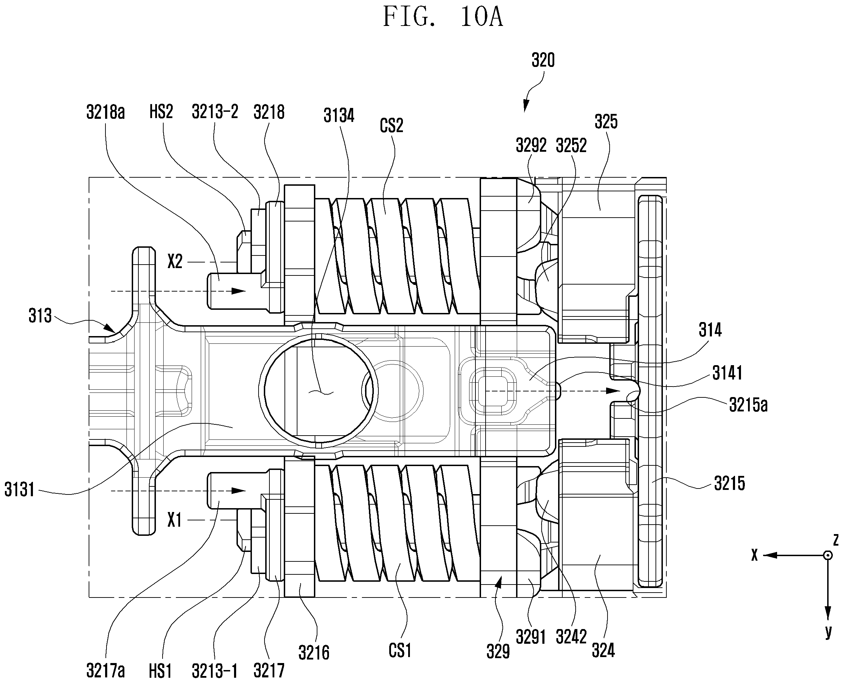

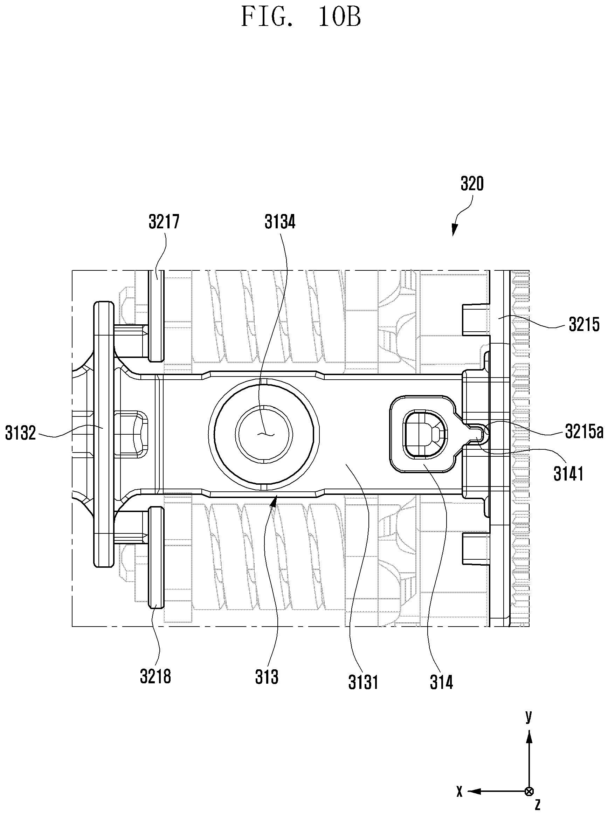

FIGS. 10A to 10C are diagrams illustrating a coupling structure of a guide damper and a hinge device according to various embodiments of the disclosure.

With reference to FIGS. 10A to 10C, in the case that the center plate 313 is disposed between a first support plate (e.g., the first support plate 311 of FIG. 3A) and a second support plate (e.g., the second support plate 312 of FIG. 3A), the protruding portion 3141 of the guide damper 314 disposed to protrude from the center plate 313 may be received in the guide slit 3215a formed in the gear support 3215 of the hinge device 320 to be guided. In an embodiment, as the center plate 313 advances in the -x axis direction toward the hinge device 320, the protruding portion 3141 of the guide damper 314 may be received in the guide slit 3215a of the gear support 3215. For example, such a coupling structure of the protruding portion 3141 and the guide slit 3215a in the -x axis direction may help improve the assembly of the hinge assembly HA. At the same time, the first protrusion 3217a of the first rotation member 3217 may be disposed to penetrate the first opening 3132a of the center plate 313, and the second protrusion 3218a may be disposed to penetrate the second opening 3132b of the center plate 313. In an embodiment, in the case that the center plate 313 is completely coupled to the hinge device 320 and that the electronic device 100 is changed from the unfolded state to the folded state or from the folded state to the unfolded state, the center plate 313 may reciprocate in a direction (e.g., ±z axis direction) perpendicular to the first rotation axis X1 and/or the second rotation axis X2. For example, a movement distance of the center plate 313 in the ±z axis direction may be proportional to at least one of a separation distance at which the first protrusion 3217a is positioned from the first rotation axis X1, a size of the first protrusion 3217a, or a rotation angle of the first protrusion 3217a for performing a circular motion based on the first rotation axis X1 or may be determined through at least one thereof. For example, a movement distance of the center plate 313 in the ±z axis direction may be determined through at least one of a separation distance at which the second protrusion 3218a is positioned from the second rotation axis X2, a size of the second protrusion 3218a, or a rotation angle of the second protrusion 3218a for performing a circular motion based on the second rotation axis X2. At the same time, the protruding portion 3141 of the guide damper 314 may be also moved along the guide slit 3215a of the gear support 3215. In an embodiment, as the guide damper 314 and/or the protruding portion 3141 are made of an elastic material, the guide damper 314 and/or the protruding portion 3141 may help reduce an impact to peripheral parts due to distortion of the center plate 313 during operation or an external impact after the guide damper 314 and/or the protruding portion 3141 are received in the guide slit 3215a. In some embodiments, the guide damper 314 and the protruding portion 3141 may be made of a hard material (e.g., metal or polymer), and an elastic material may be disposed in the guide slit 3215a. In some embodiments, the elastic material may be applied to both the guide damper 314 and the guide slit 3215a. In an embodiment, the protruding portion 3141 and the guide slit 3215a may be formed to have the same length. In some embodiments, the protruding portion 3141 may be formed to have a length shorter or longer than that of the guide slit 3215a. In some embodiments, the guide slit 3215a may be formed in another component (e.g., the support 321) of the hinge device. In some embodiments, in the guide slit 3215a, a protruding portion (not illustrated) protruded in the direction of the guide damper (e.g., the first guide damper 314) may be formed. For example, the guide slit 3215a may include a protruded protruding portion and a slit (not illustrated) may be formed in the guide damper (e.g., the first guide damper 314); thus, the protruded protruding portion of the guide slit 3215a may be moved along the slit of the guide damper (e.g., the first guide damper 314).

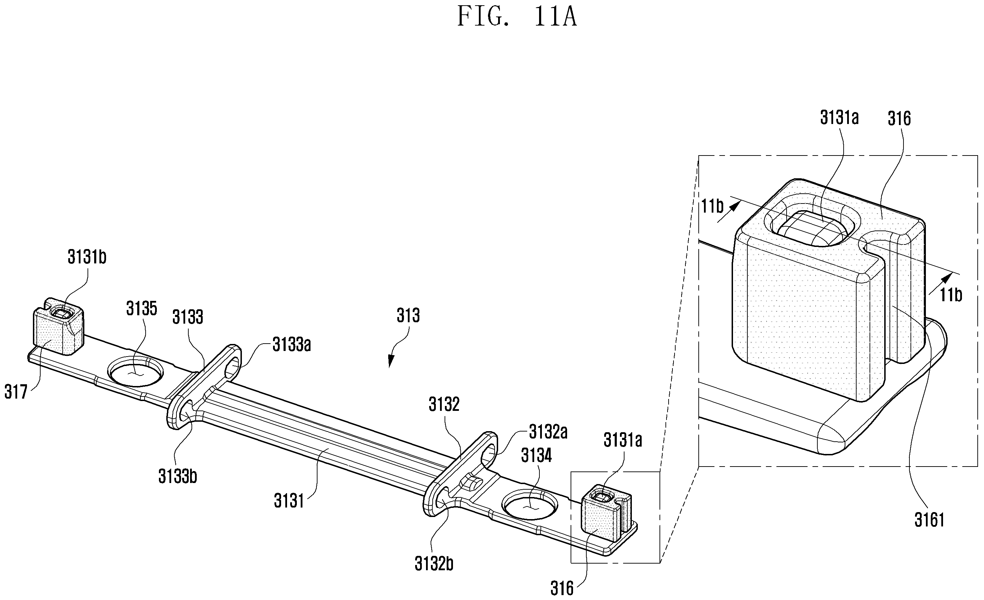

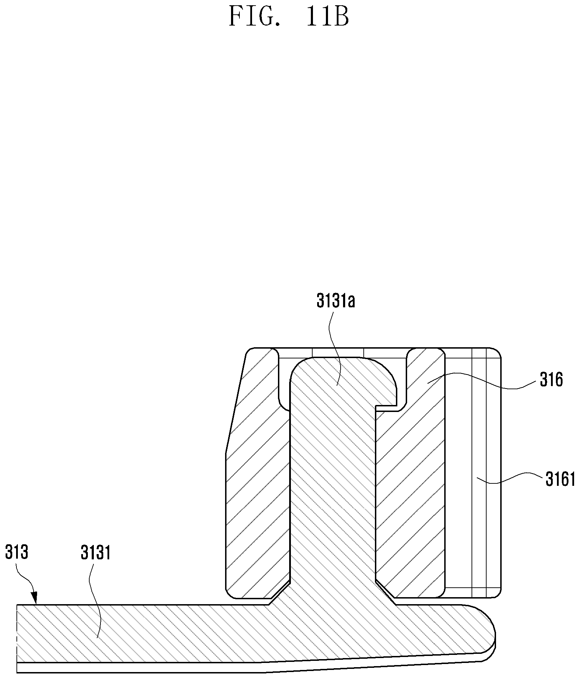

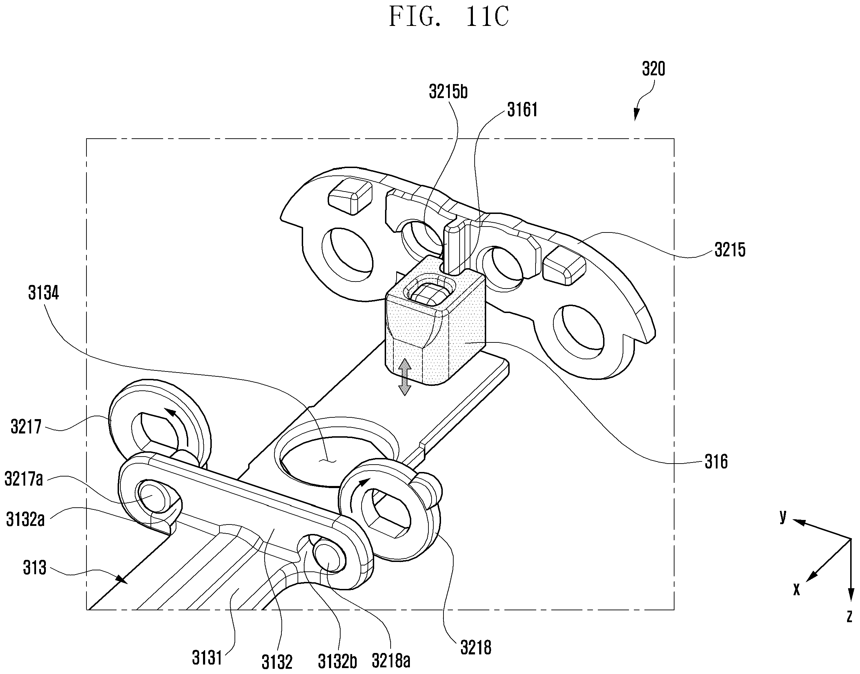

FIG. 11A is a perspective view of a center plate according to various embodiments of the disclosure. FIG. 11B is a partial cross-sectional view of the center plate viewed along line 11b-11b of FIG. 11A according to various embodiments of the disclosure. FIG. 11C is a diagram illustrating a state in which a guide damper of FIG. 11A is coupled to a gear support of a hinge device according to various embodiments of the disclosure.

In describing the center plate 313 of FIGS. 11A to 11C, the same reference numerals are given to substantially the same components as those of the center plate 313 of FIGS. 8A to 8D, and detailed descriptions thereof may be omitted.

With reference to FIGS. 11A to 11C, the center plate 313 may include a first guide damper 316 disposed at one end of the plate portion 3131 and a second guide damper 317 disposed at the other end thereof. In an embodiment, the first guide damper 316 may be fixed in a manner in which a hook-shaped first mounting protrusion 3131a protruded from the plate portion 3131 is inserted, and the second guide damper 317 may be fixed in a manner in which a hook-shaped second mounting protrusion 3131b protruded from the plate portion 3131 is inserted.

According to various embodiments, the guide damper 316 may include a guide slit 3161 recessed inward and having a length in a direction perpendicular to the plate portion 3131. For example, the guide slit 3161 may include an at least partially injected injection molded product (e.g., polymer material or elastic material) in order to prevent deformation due to friction or the like during operation. In some embodiments, the guide slit 3161 may include a material equivalent to the injection molded product through bonding, taping, fusion, or structural coupling in addition to injection molding. In an embodiment, in the case that the center plate 313 is disposed between the first support plate (e.g., the first support plate 311 of FIG. 3A) and the second support plate (e.g., the second support plate 312 of FIG. 3A), the guide damper 316 disposed to protrude from the center plate 313 may be guided to receive the guide protrusion 3215b formed in the gear support 3215 of the hinge device 320 in the guide slit 3161. In an embodiment, as the center plate 313 advances in the -x axis direction toward the hinge device 320, the guide protrusion 3215b of the gear support 3215 may be received in the guide slit 3161 of the guide damper 316. Therefore, in the case that the center plate 313 is completely coupled to the hinge device 320 and that the electronic device 100 is changed from the unfolded state to the folded state or from the folded state to the unfolded state, the center plate 313 may reciprocate in a direction (e.g., ±z axis direction) perpendicular to the first rotation axis X1 and/or the second rotation axis X2 through a coupling structure of the guide slit 3161 of the guide damper 316 and the guide protrusion 3215b of the gear support 3215.

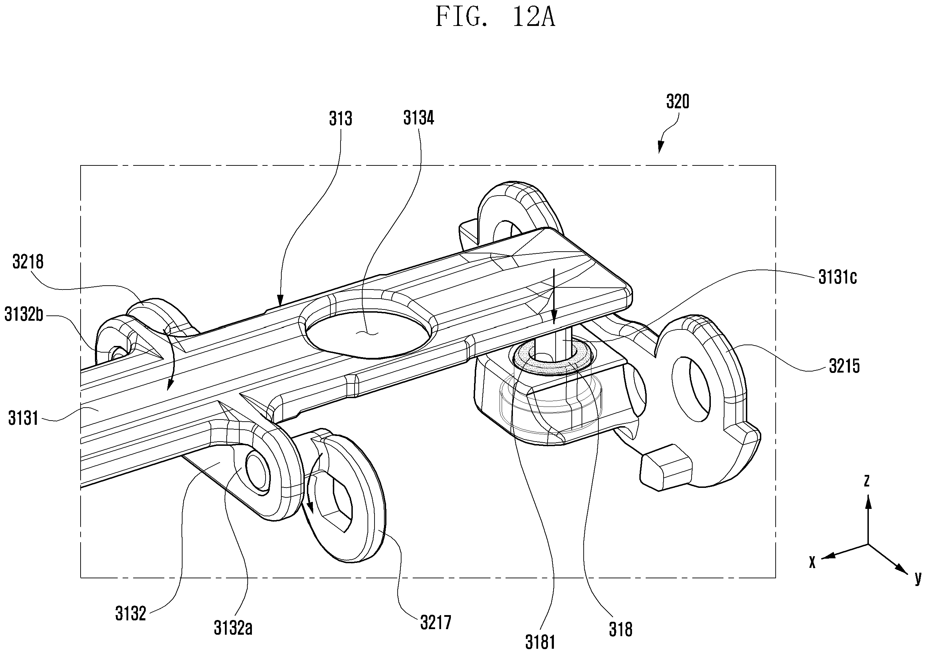

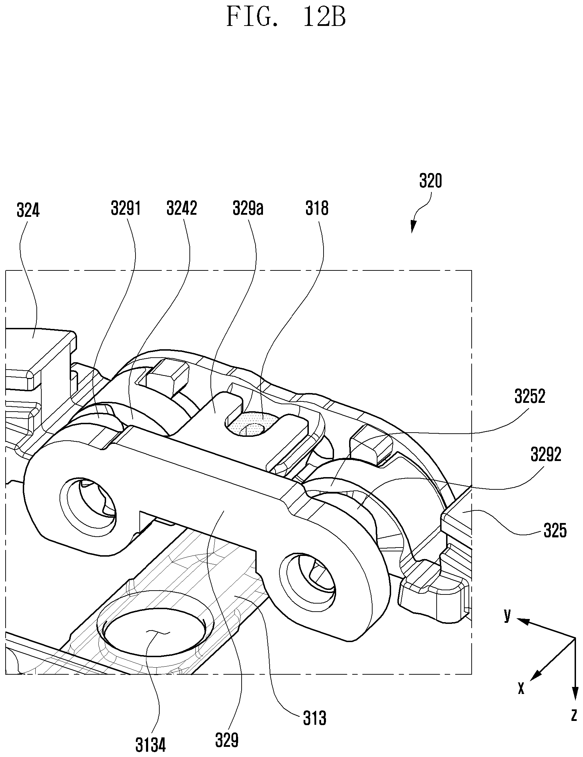

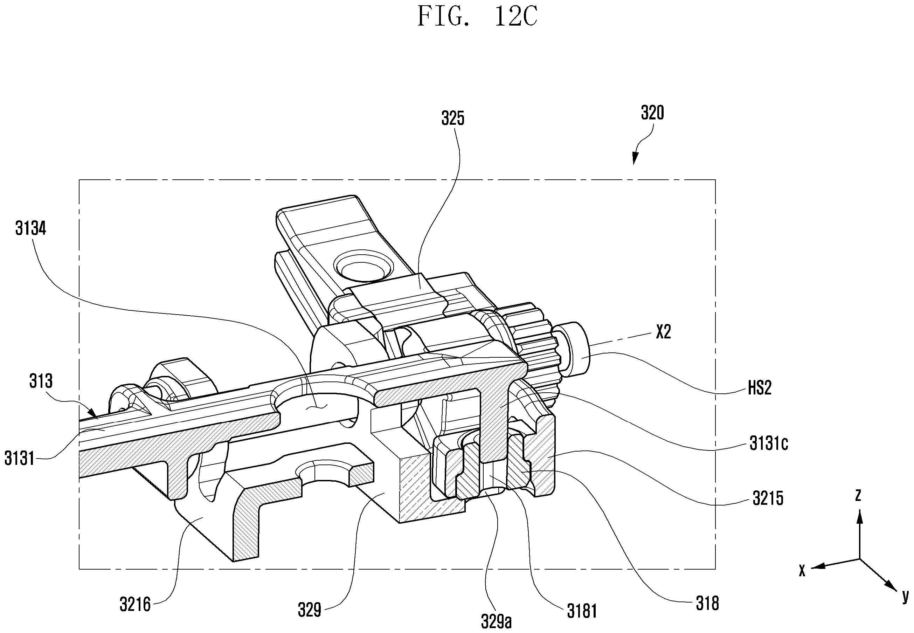

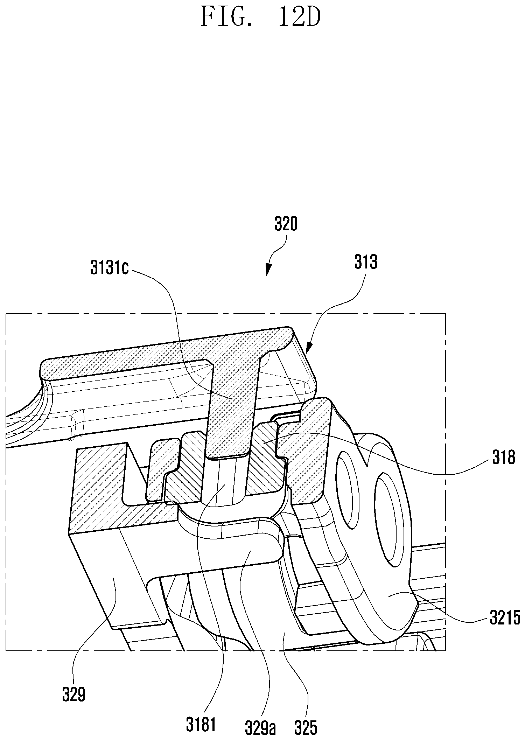

FIGS. 12A to 12D are diagrams illustrating a state in which a center plate is coupled to a gear assembly of a hinge device through a guide damper according to various embodiments of the disclosure.

In describing the center plate 313 of FIGS. 12A to 12D, the same reference numerals are assigned to substantially the same components as those of the center plate 313 of FIGS. 8A to 8D, and detailed descriptions thereof may be omitted.

With reference to FIGS. 12A to 12D, the center plate 313 may include a mounting protrusion 3131c protruded from the plate portion 3131 and a guide damper 318 of an elastic material disposed in the gear support 3215. In an embodiment, the guide damper 318 may include a guide groove 3181, and the mounting protrusion 3131c may be coupled by being inserted into the guide groove 3181. In an embodiment, the guide damper 318 may be coupled in an injection method or structurally coupled to the gear support 3215. In this case, the mounting protrusion 3131c of the center plate 313 may be coupled to the guide groove 3181 of the guide damper 318 in a direction (e.g., -z axis direction) perpendicular to the first rotation axis (e.g., the first rotation axis X1 of FIG. 4) or the second rotation axis (e.g., the second rotation axis X2 of FIG. 4). Accordingly, in the case that the center plate 313 is completely coupled to the hinge device 320 and that the electronic device 100 is changed from the unfolded state to the folded state or from the folded state to the unfolded state, the mounting protrusion 3131c of the center plate 313 may reciprocate in a direction (e.g., ±z axis direction) perpendicular to the first rotation axis X1 and/or the second rotation axis X2 along the guide groove 3181 of the guide damper 318.

According to various embodiments, the hinge device 320 may be disposed so that the first cam element 3242 of the first hinge arm 324 engages with the third cam element 3291 of the cam structure 329 and that the second cam element 3252 of the second hinge arm engages with the fourth cam element 3292 of the cam structure 329. For example, in the case that the first hinge arm 324 rotates based on the first rotation axis X1 together with the first shaft (e.g., the first shaft HS1 of FIG. 4) and that the second hinge arm 325 rotates based on the second rotation axis X2 together with the second shaft (e.g., the second shaft HS2 of FIG. 4), the cam structure 329 cam-coupled therewith may be retracted rearward (e.g., x-axis direction). In this case, the first cam element 3242 and the second cam element 3252 rotate while engaging with the third cam element 3291 and the fourth cam element 3292, and the cam structure 329 instantaneously changes a direction to the opposite direction (e.g., -x axis direction) based on a certain inflection point; thus, a bounce phenomenon (junction phenomenon) may occur. Such a phenomenon may provide discomfort to the user.

The hinge device 320 according to an exemplary embodiment of the disclosure may include an overlapping portion 329a extended from the cam structure 329, and when the center plate 313 is viewed from above, the overlapping portion 329a may be disposed to at least partially overlap with the guide damper 318 of an elastic material. Through an overlapped structure of the overlapping portion 329a of the cam structure 329 and the guide damper 318, a frictional force is provided to the cam structure 329; thus, the cam structure 329 may be flexibly (relatively slowly) moved to the above-described bounce phenomenon. Accordingly, the sudden bounce phenomenon of the cam structure 329 due to a rotation of the hinge arms 324 and 325 may be reduced, and improved operational reliability may be provided to the user.

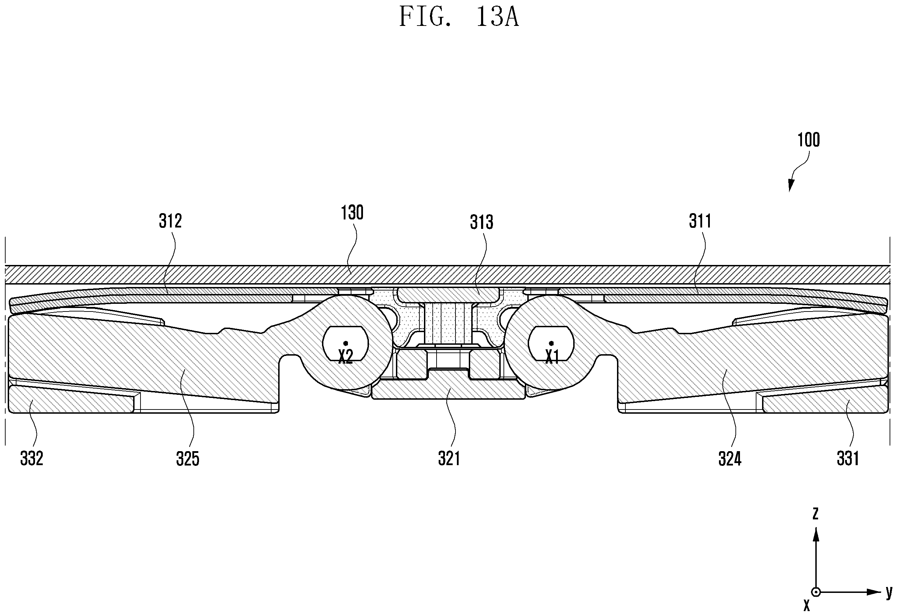

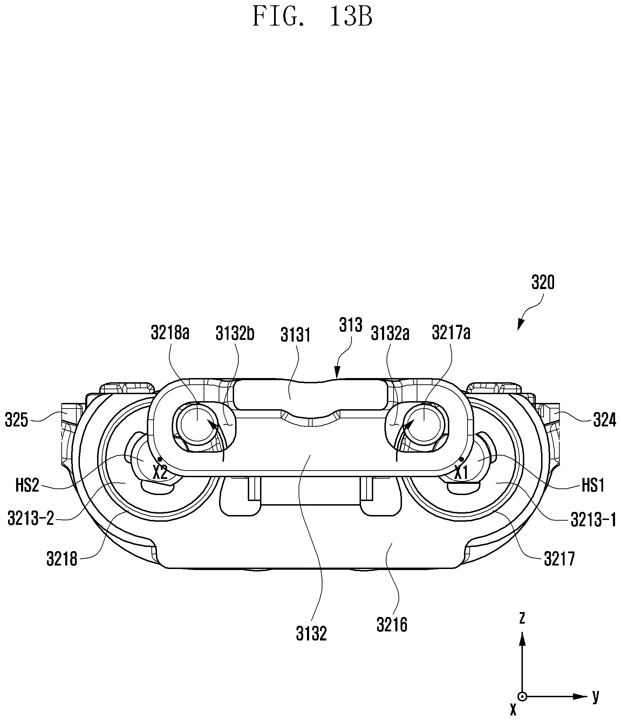

FIG. 13A is a partial cross-sectional view of an electronic device illustrating an unfolded state according to various embodiments of the disclosure. FIG. 13B is a diagram of a hinge device illustrating a position of a center plate in the state of FIG. 13A according to various embodiments of the disclosure.

With reference to FIGS. 13A and 13B, the electronic device 100 may include a first rotation member 3217 coupled to the first shaft HS1 rotating based on the first rotation axis X1 and including a first protrusion 3217a and a second rotation member 3218 coupled to the second shaft HS2 rotating based on the second rotation axis X2 and including a second protrusion 3218a. In an embodiment, the first protrusion 3217a may maintain a state penetrated in a first opening 3132a formed in a guide portion 3132 extended from a plate portion 3131 of the center plate 313, and the second protrusion 3218a may maintain a state penetrated in a second opening 3132b formed in the guide portion 3132 of the center plate 313.

According to various embodiments, when the electronic device 100 is changed from a folded state to an unfolded state, the first hinge arm 324 and the second hinge arm 325 may rotate simultaneously, the first rotation member 3217 may rotate clockwise based on the first rotation axis X1, and the second rotation member 3218 may rotate counterclockwise based on the second rotation axis X2. At the same time, the first protrusion 3217a may move upward through a circular motion based on the first rotation axis X1, and the second protrusion 3218a may move upward through a circular motion based on the second rotation axis X2. By moving the first protrusion 3217a and the second protrusion 3218a through a circular motion, the center plate 313 may be moved upward (e.g., z-axis direction) to form the same plane as that of the first support plate 311 and the second support plate 312, thereby smoothly supporting the flexible display 130.

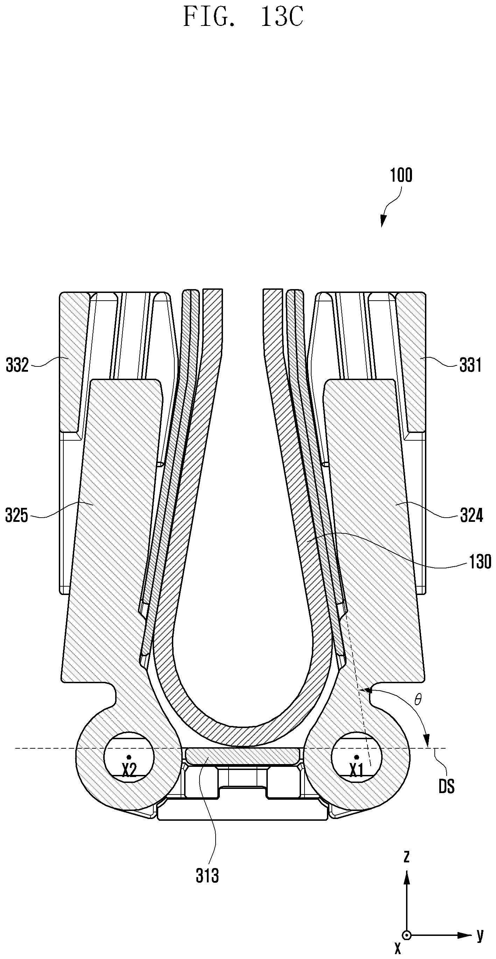

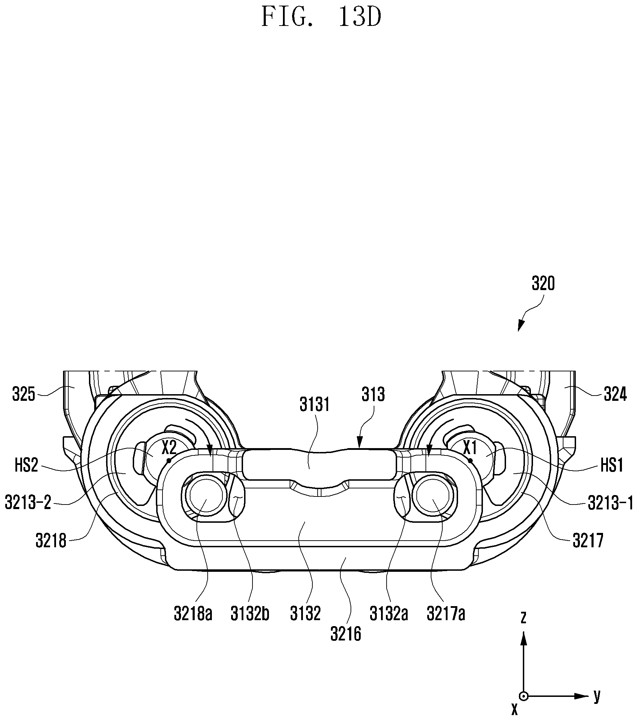

FIG. 13C is a partial cross-sectional view of an electronic device illustrating a folded state according to various embodiments of the disclosure. FIG. 13D is a diagram of a hinge device illustrating a position of a center plate in the state of FIG. 13C according to various embodiments of the disclosure.

With reference to FIGS. 13C and 13D, in the case that the electronic device 100 is changed from an unfolded state to a folded state, the support plates 311 and 312 may rotate to form a specific angle θ with respect to a display surface DS in the unfolded state while supporting the flexible display 130. In an embodiment, the specific angle θ may be 90 degrees or include angles greater than 90 degrees.

According to various embodiments, when the electronic device 100 is changed from the unfolded state to the folded state, the first hinge arm 324 and the second hinge arm 325 may rotate simultaneously, and the first rotation member 3217 may rotate counterclockwise based on the first rotation axis X1, and the second rotation member 3218 may rotate clockwise based on the second rotation axis X2. At the same time, the first protrusion 3217a may move downward through a circular motion based on the first rotation axis X1, and the second protrusion 3218a may move downward through a circular motion based on the second rotation axis X2. By moving the first protrusion 3217a and the second protrusion 3218a through a circular motion, the center plate 313 may be moved downward (e.g., -z-axis direction). In this case, the center plate 313 may be disposed in contact with or close to the rear surface of the flexible display 130 under a bending area of the flexible display 130.

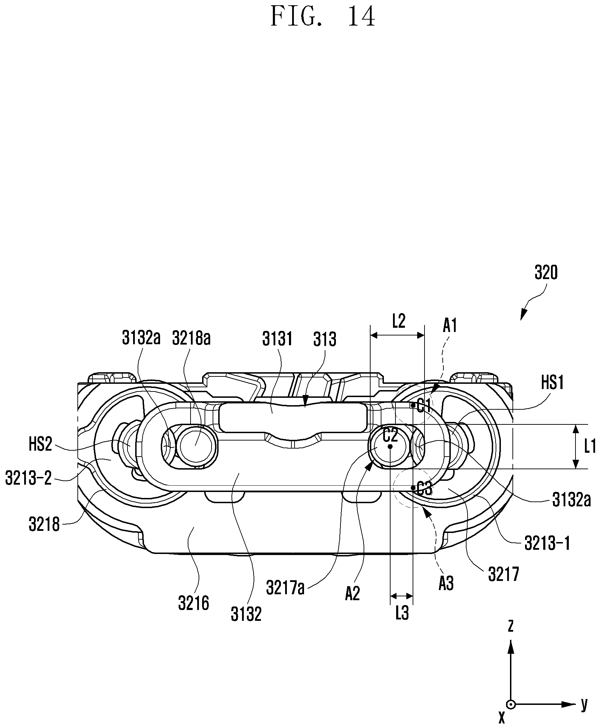

FIG. 14 is a diagram of a portion of a hinge device illustrating the disposition relationship between a protrusion and an opening according to various embodiments of the disclosure.

With reference to FIG. 14, the electronic device 100 may include a first rotation member 3217 coupled to the first shaft HS1 rotating based on the first rotation axis X1 and including a first protrusion 3217a and a second rotation member 3218 coupled to the second shaft HS2 rotating based on the second rotation axis X2 and including a second protrusion 3218a. In an embodiment, the first protrusion 3217a may maintain a state penetrated in a first opening 3132a formed in a guide portion 3132 extended from a plate portion 3131 of the center plate 313, and the second protrusion 3218a may maintain a state penetrated in a second opening 3132b formed in the guide portion 3132 of the center plate 313.

According to various embodiments, the first opening 3132a may be disposed to have a size larger than the cross section of the first protrusion 3217a. In an embodiment, the first opening 3132a may have a first length 11 in the z-axis direction and be formed in a shape of a long hole (or oval) having a second length 12 longer than the first length 11 in the y-axis direction perpendicular to the z-axis. In an embodiment, the second length 12 may be formed to have an extra length 13 that can receive a horizontal distance 13 (e.g., the distance in the y-axis direction) from the center C1 (e.g., the center in an area A1) of the first protrusion 3217a in a fully unfolded state of the electronic device 100 and/or from the center C3 (e.g., the center in an area A3) of the first protrusion 3217a in a fully folded state of the electronic device 100 to the center C2 (e.g., the center in an area A2) of the first protrusion 3217a when the state of the electronic device 100 is changed to an intermediate state. In some embodiments, the first opening 3132a may be formed not in the form of a long hole but in a square, polygon, or other various shapes. In an embodiment, the second opening 3132b may also be formed in substantially the same manner as that of the first opening 3132a. In an embodiment, a third opening 3133a and a fourth opening 3133b may be formed in substantially the same manner as that of the first opening 3132a.

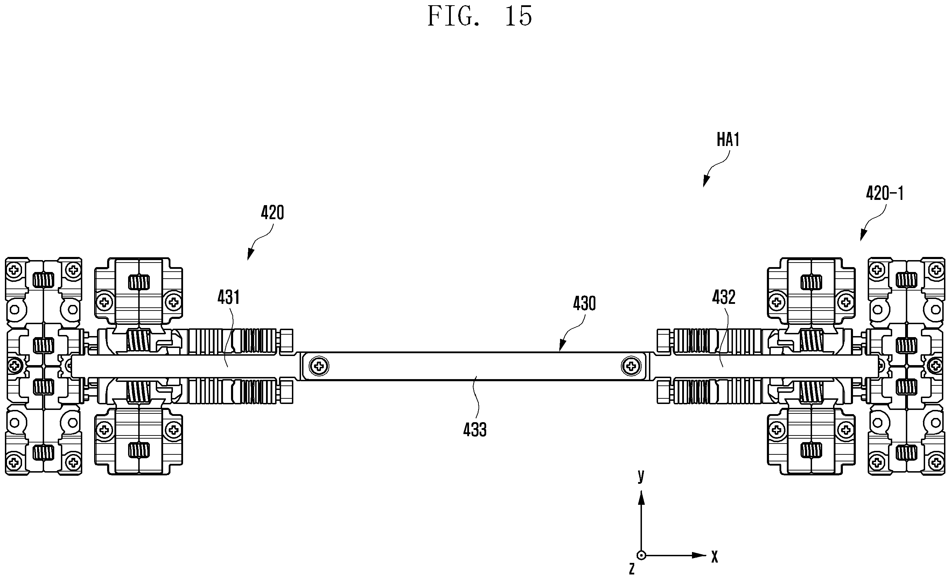

FIG. 15 is a diagram a constitution of a hinge assembly according to various embodiments of the disclosure.

With reference to FIG. 15, the hinge assembly HA1 may include a first hinge device 420, a second hinge device 420-1 spaced apart from the first hinge device 420, and a center plate 430 disposed between the first hinge device 420 and the second hinge device 420-1 and disposed movably in a vertical direction (e.g., ±z axis direction) according to a folding operation and unfolding operation of the first housing (e.g., the first housing 110 of FIG. 3A) and the second housing (e.g., the second housing 120 of FIG. 3A). In an embodiment, the center plate 430 may be moved to form the same plane as that of the first support plate (e.g., the first support plate 311 of FIG. 3A) and the second support plate (e.g., the second support plate 312 of FIG. 3A) in an unfolded state of the electronic device (e.g., the electronic device 100 of FIG. 3A).

According to various embodiments, the center plate 430 may include a first center plate 431 movably coupled to a first hinge device 420, a second center plate 432 movably coupled to a second hinge device 420-1, and a connection plate 433 for connecting the first center plate 431 and the second center plate 432. In some embodiments, the center plate 430 may be integrally formed as one plate without the first center plate 431 and the second center plate 432 and the connecting plate 433.

Hereinafter, in describing the drawings, the structure in which the first center plate 431 is coupled to the first hinge device 420 is illustrated and described, but it is obvious that the coupling structure of the second center plate 432 and the second hinge device 420-1 may also have substantially the same constitution.

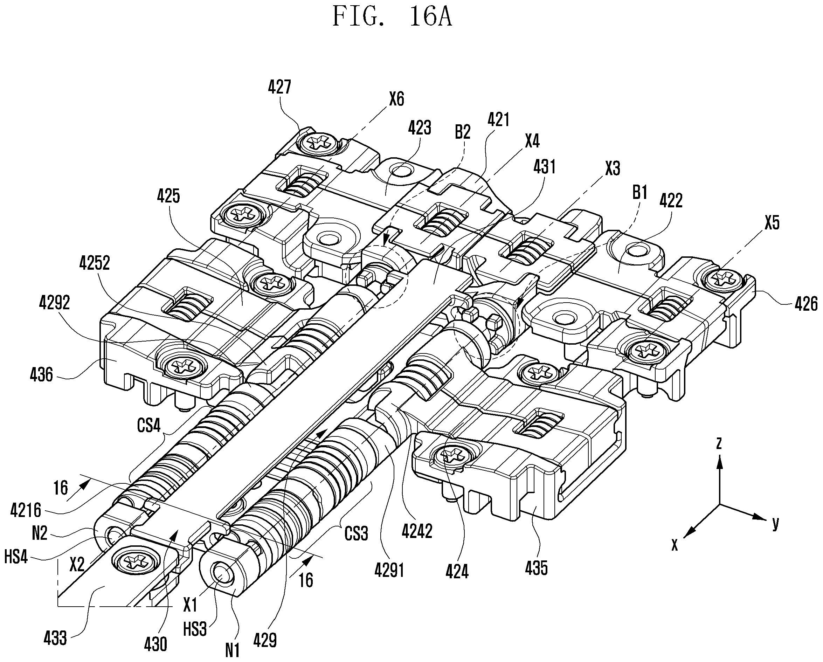

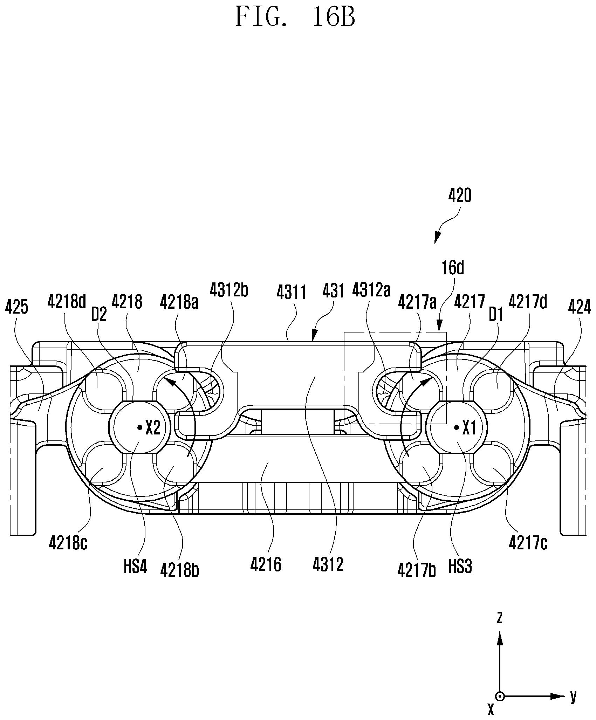

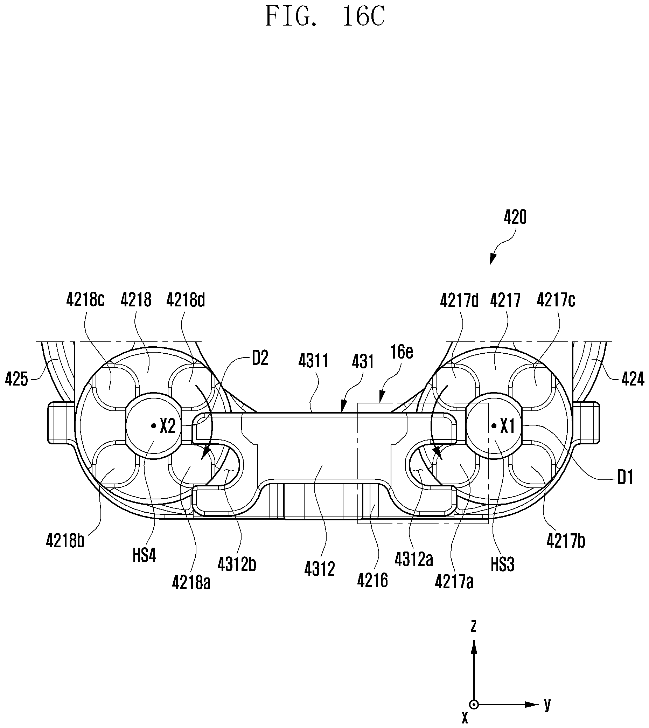

FIG. 16A is a diagram illustrating a constitution of a hinge device of FIG. 15 according to various embodiments of the disclosure. FIGS. 16B and 16C are diagrams illustrating an operation structure of a center plate according to the rotation of a protrusion according to various embodiments of the disclosure.

With reference to FIGS. 16A to 16C, the hinge device 420 (e.g., the first hinge device 420 of FIG. 15) may include a support 421 (e.g., rotator bracket or bracket) fixed to the hinge housing (e.g., the hinge housing 141 of FIG. 3A) through a fastening member such as a screw, a first shaft HS3 rotatably disposed in the support 421 based on the first rotation axis X1, a second shaft HS4 rotatably disposed in the support 421 based on the second rotation axis X2 spaced apart from the first rotation axis X1, a first rotator 422 rotatably disposed in the support 421 based on the third rotation axis X3, a second rotator 423 rotatably disposed in the support 421 based on the fourth rotation axis X4, a first fixed body 426 rotatably coupled to the first rotator 422 based on the fifth rotation axis X5, a second fixed body 427 rotatably coupled to the second rotator 423 based on the sixth rotation axis X6, a first hinge arm 424 having one end coupled to the first shaft HS3 so as to be rotatable based on the first rotation axis X1, and a second hinge arm 425 having one end coupled to the second shaft HS4 so as to be rotatable based on the second rotation axis X2. In an embodiment, the first fixed body 426 may be fixed to the first housing (e.g., the first housing 110 of FIG. 3A). In an embodiment, the second fixed body 427 may be fixed to the second housing (e.g., the second housing 120 of FIG. 3A). In an embodiment, the hinge device 420 may include a first link 435 fixed to the first housing (e.g., the first housing 110 of FIG. 3A) and for movably guiding the other end of the first hinge arm 424 and a second link 436 fixed to the second housing (e.g., the second housing 120 of FIG. 3A) and for movably guiding the other end of the second hinge arm 425. In an embodiment, the first link 435 may be fixed to the first housing (e.g., the first housing 110 of FIG. 3A), and the second link 436 may be fixed to the second housing (e.g., the second housing 120 of FIG. 3A).

According to various embodiments, the first hinge arm 424 may include a first cam element 4242 formed in one side. According to an embodiment, the second hinge arm 425 may include a second cam element 4252 formed in one side. In an embodiment, the first link 435 may move linearly from the first hinge arm 424 through a guide structure movably coupled to the first hinge arm 424 in a linear shape or a curved shape or may be rotably disposed based on another rotation axis. In an embodiment, the second link 436 may move linearly from the second hinge arm 425 through a guide structure movably coupled to the second hinge arm 425 in a linear shape or a curved shape or may be rotatably disposed based on another rotation axis.

According to various embodiments, the hinge device 420 may include a third cam element 4291 cam-coupled with the first cam element 4242 and a fourth cam element 4292 cam-coupled with the second cam element 4252. In an embodiment, the first cam element 4242 may be disposed in a manner in which the first shaft HS3 penetrates. In an embodiment, the second cam element 4252 may be disposed in a manner in which the second shaft HS4 penetrates. In an embodiment, the hinge device 420 may include elastic members CS3 and CS4 (e.g., disk spring or compression coil spring) disposed in a manner in which the first shaft HS3 and the second shaft HS4 penetrate and for pressing the third cam element 4291 and the fourth cam element 4292 in the direction (e.g., -x-axis direction) of the first hinge arm 424 and the second hinge arm 425, respectively based on the shaft support 4216.

According to various embodiments, the first hinge arm 424 may rotate based on the first rotation axis X1. In an embodiment, the first cam element 4242, the third cam element 4291, the elastic member CS3, and the shaft support 4216 of the first hinge arm 424 may be aligned sequentially through the first shaft HS3 penetrating them. In an embodiment, the second hinge arm 425 may rotate based on the second rotation axis X2. In an embodiment, the second cam element 4252, the fourth cam element 4292, the elastic member CS4, and the shaft support 4216 of the second hinge arm 425 may be aligned sequentially through the second shaft HS4 penetrating them. In an embodiment, the first shaft HS3 and the second shaft HS4 may be restrained from being separated through fixing members (e.g., nuts) N1 and N2. In an embodiment, the fastening members N1 and N2, in the case of nuts, may be rotatably screw-coupled to end portions of the shafts HS3 and HS4.

According to various embodiments, the third cam element 4291 and the fourth cam element 4292 may be moved in a direction (e.g., -x axis direction) parallel to the first rotation axis X1 and the second rotation axis X2. The first cam element 4242 of the first hinge arm 424 may be rotatably disposed based on the first rotation axis X1, and the second cam element 4252 of the second hinge arm 425 may be rotatably disposed based on the second rotation axis X2. In an embodiment, when the first cam element 4242 is rotated by the first hinge arm 424 based on the first rotation axis X1, a torque may be generated while the third cam element 4291 cam-coupled and supported by the elastic member CS3 retracts rearward. Likewise, when the second cam element 4252 is rotated by the second hinge arm 425 based on the second rotation axis, a torque may be generated while the fourth cam element 4292 cam-coupled and supported by the elastic member CS4 retracts rearward. In an embodiment, the magnitude of the torque may be determined according to a shape of the first cam element 4242 and the third cam element 4291 coupled therewith and a shape of the second cam element 4252 and the fourth cam element 4292 coupled therewith, and the first housing (e.g., the first housing 110 of FIG. 3A) and the second housing (e.g., the second housing 120 of FIG. 3A) may be configured to be pressed in the direction unfolded or folded at a designated inflection angle or more by the determined torque or to stop at a designated folding angle.

According to various embodiments, the hinge device 420 may include a first rotation member 4217 disposed between the shaft support 4216 and the fixing member N1 in a manner in which the first shaft HS3 penetrates, and a second rotation member 4218 disposed between the shaft support 4216 and the fixing member N2 in a manner in which the second shaft HS4 penetrates. In an embodiment, the first rotation member 4217 may be coupled to rotate with the first shaft HS3 and the fixing member N1. In an embodiment, the second rotation member 4218 may be coupled to rotate with the second shaft HS4 and the fixing member N2. In an embodiment, the first rotation member 4217 may include a first protrusion 4217a protruded outward to perform a circular motion based on the first rotation axis X1 at a position spaced apart from the first rotation axis X1. In an embodiment, the second rotation member 4218 may include a second protrusion 4218a protruded outward to perform a circular motion based on the second rotation axis X2 at a position spaced apart from the second rotation axis X2.

According to various embodiments, the center plate 431 may include a plate portion 4311, a guide portion 4312 extended from the plate portion 4311, and a first opening 4312a and second opening 4312b formed in the guide portion 4312. In an embodiment, the first opening 4312a may be coupled to interlock with the first protrusion 4217a. In an embodiment, the second opening 4312b may be coupled to interlock with the second protrusion 4218a. In an embodiment, the first opening 4312a may be formed in an open shape (e.g., 'C' shape) (e.g., first partial opening) in the direction of the first protrusion 4217a. In an embodiment, the second opening 4312b may be formed in an open shape (e.g., 'C' shape) (e.g., second partial opening) in the direction of the second protrusion 4218a. In an embodiment, the first protrusion 4217a may be disposed to penetrate the first opening 4312a, and the second protrusion 4218a may be disposed to penetrate the second opening 4312b. In an embodiment, the center plate 431 may be induced to move linearly in a vertical direction (e.g., ±z-axis direction) by a circular motion of the first protrusion 4217a and the second protrusion 4218a. In an embodiment, the first rotation member 4217 and the second rotation member 4218 may be used as a washer member for preventing the fixing members N1 and N2 from being separated by direct transmission of the pressing force by indirectly transmitting a pressing force provided by the elastic members CS3 and CS4 between the shaft support 4216 and the fixing members N1 and N2 to the fixing members N1 and N2. For example, in the case that the fixing members N1 and N2 are used as nuts, a contact with the shaft support 4216 is avoided through the first rotation member 4217 and the second rotation member 4218; thus, the phenomenon of screw loosening may be reduced by a rotation of the shafts HS3 and HS4. In an embodiment, the first rotation member 4217 may include at least one additional protrusion 4217b, 4217c, and 4217d protruded around the first protrusion 4217a in order to reinforce a fastening force by expanding a contact surface with the fixing member N1. In an embodiment, the second rotation member 4218 may also include at least one additional protrusion 4218b, 4218c, and 4218d protruded around the second protrusion 4218a in order to reinforce a fastening force by expanding a contact surface with the fixing member N2. In an embodiment, additional protrusions 4217b, 4217c, and 4217d protruded around the first protrusion 4217a may be formed symmetrically in the left-right direction and/or up-down direction together with the first protrusion 4217a. In an embodiment, additional protrusions 4218b, 4218c, and 4218d protruded around the second protrusion 4218a may be formed symmetrically in the left-right direction and/or up-down direction together with the second protrusion 4218a. With reference to FIG. 16B, when the electronic device (e.g., the electronic device 100 of FIG. 3A) is changed from the folded state to the unfolded state, the first hinge arm 424 and the second hinge arm 425 may be rotated simultaneously, and the first rotation member 4217 may rotate clockwise based on the first rotation axis X1, and the second rotation member 4218 may rotate counterclockwise based on the second rotation axis X2. At the same time, the first protrusion 4217a may move upward through a circular motion based on the first rotation axis X1, and the second protrusion 4218a may move upward through a circular motion based on the second rotation axis X2.

With reference to FIG. 16C, when the electronic device (e.g., the electronic device 100 of FIG. 3A) is changed from the unfolded state to the folded state, the first hinge arm 424 and the second hinge arm 425 may rotate simultaneously, the first rotation member 4217 may rotate counterclockwise based on the first rotation axis X1, and the second rotation member 4218 may rotate clockwise based on the second rotation axis X2. At the same time, the first protrusion 4217a may move downward through a circular motion based on the first rotation axis X1, and the second protrusion 4218a may move downward through a circular motion based on the second rotation axis X2. By moving the first protrusion 4217a and the second protrusion 4218a through a circular motion, the center plate 431 may be moved downward (e.g., -z-axis direction).

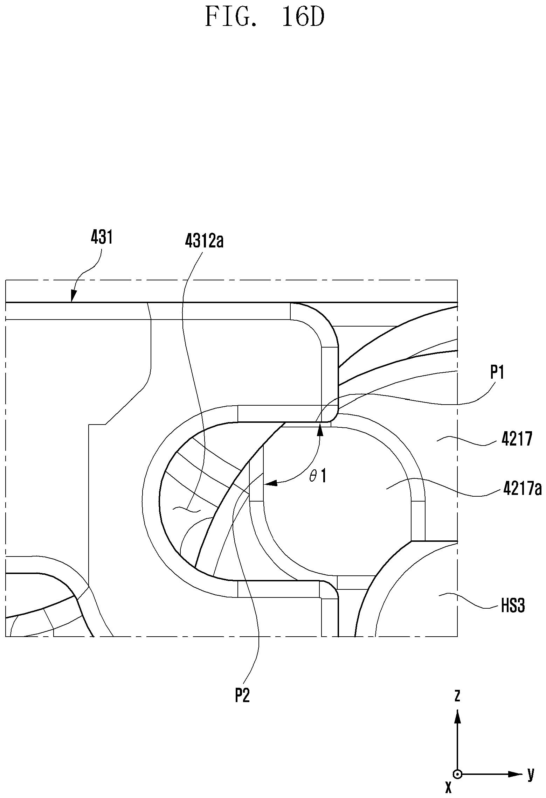

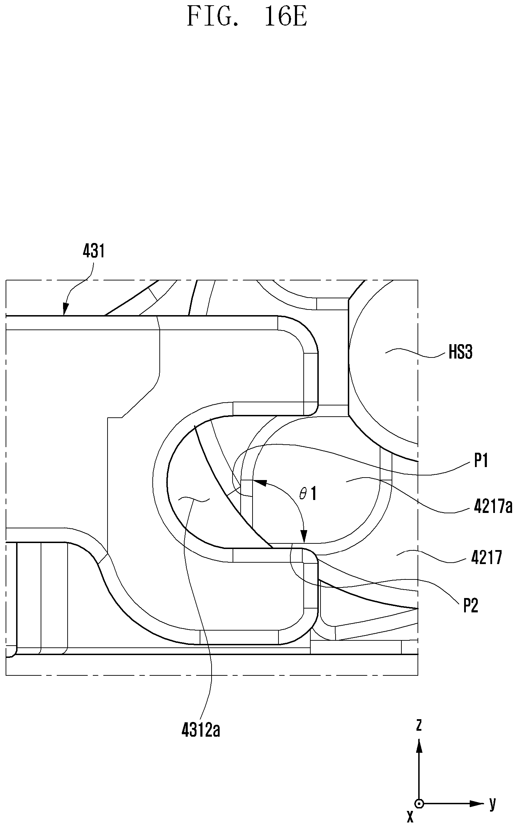

FIG. 16D is an enlarged view of an area 16d of FIG. 16B according to various embodiments of the disclosure. FIG. 16E is an enlarged view of an area 16e of FIG. 16C according to various embodiments of the disclosure.

With reference to FIGS. 16D and 16E, the first protrusion 4217a may be formed in the center plate 431 and have a shape for stably supporting an upper portion and a lower portion of the first opening 4312a while operating and securing a hooking amount with the first opening 4312a. In an embodiment, the first protrusion 4217a may include a first flat portion P1 formed to stably perform a surface contact with the upper portion of the first opening 4312a while the electronic device 100 is changed from the folded state to the unfolded state. In an embodiment, while the first protrusion 4217a is extended from the first flat portion P1 at a designated angle θ1 and the electronic device 100 is changed from the unfolded state to the folded state, the first protrusion 4217a may include a second flat portion P2 formed to stably perform a surface contact with the lower portion of the first opening 4312a.

According to various embodiments, an angle θ1 formed by the first flat portion P1 and the second flat portion P2 may be determined by a rotation angle of the first hinge arm 424 rotated based on the first rotation axis X1. For example, when the electronic device 100 operates in an unfolded state of 180 degrees and the first hinge arm 424 has a rotation angle of about 85 degrees from the folded state to the unfolded state, the angle θ1 of the first flat portion P1 and the second flat portion P2 may be formed in about 95 degrees as a result of 180 degrees-85 degrees. For example, when the first hinge arm 424 has a rotation angle of about 95 degrees from the folded state to the unfolded state, the angle θ1 between the first flat portion P1 and the second flat portion P2 may be formed in about 85 degrees. In an embodiment, the rotation angle of the first hinge arm 424 may be determined by the guide structure of the first link (e.g., the first link 435 of FIG. 16A) slidably coupled to the first hinge arm 424. For example, in the case that the rotation angle of the first hinge arm 424 is 90 degrees, the first hinge arm 424 and the first link (e.g., the first link 435 of FIG. 16A) may have a linear guide structure. For example, in the case that the rotation angle of the first hinge arm 424 is smaller than 90 degrees, the first hinge arm 424 and the first link (e.g., the first link 435 of FIG. 16A) may have a curved guide structure bent in a downward direction (e.g., -z axis direction). For example, in the case that the rotation angle of the first hinge arm 424 is greater than 90 degrees, the first hinge arm 424 and the first link (e.g., the first link 435 of FIG. 16A) may have a curved guide structure bent in an upward direction (e.g., z-axis direction). In an embodiment, the shape of the second protrusion 4218a may be also determined by a rotation angle of the second hinge arm 425 and/or the second link (e.g., the second link 436 of FIG. 16A) in substantially the same manner as that of the first protrusion 4217a.

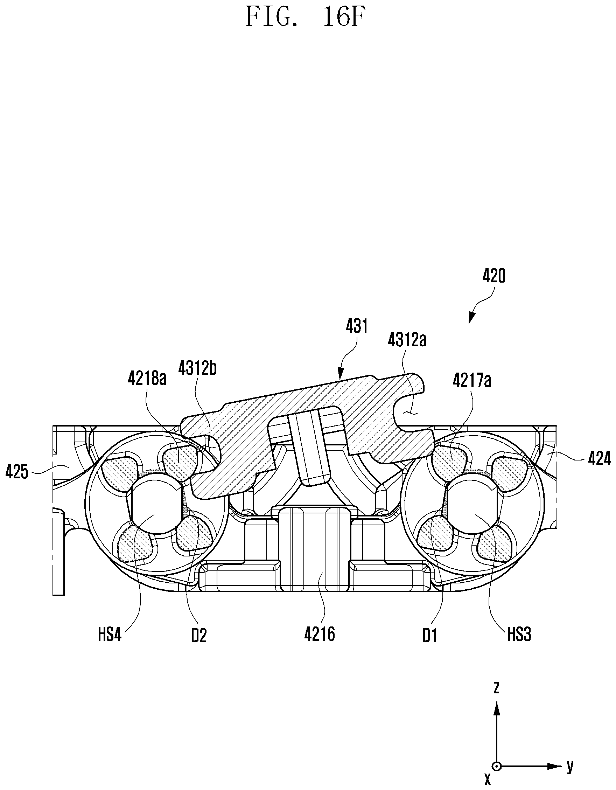

FIG. 16F is a diagram illustrating the positional relationship of cutting portions for assembling a center plate according to various embodiments of the disclosure.

With reference to FIG. 16F, the first shaft HS3 and the second shaft HS4 may include cutting portions D1 and D2 cut in a longitudinal direction (e.g., ±x axis direction) at an outer circumferential surface so as to rotate together the first rotation member 4217 and the second rotation member 4218. These cutting portions D1 and D2 may be cut in a direction in which the protrusions 4217a and 4218a may be easily received in the openings 4312a and 4312b in order to improve the assembly of the center plate 431. For example, the cutting portions D1 and D2 may be formed in a vertical direction (e.g., ±z-axis direction) in an unfolded state of the electronic device 100. For example, in order to mount the center plate 431 in the hinge device 420, when the second hinge arm 425 is pressed in a further unfolded direction in an unfolded state, the second protrusion 4218a may be more easily received in the second opening 4312b, and such an assembly process may not be interrupted through the cutting portion D2. In an embodiment, the first protrusion 4217a and the first opening 4312a may also be engaged in substantially the same manner.

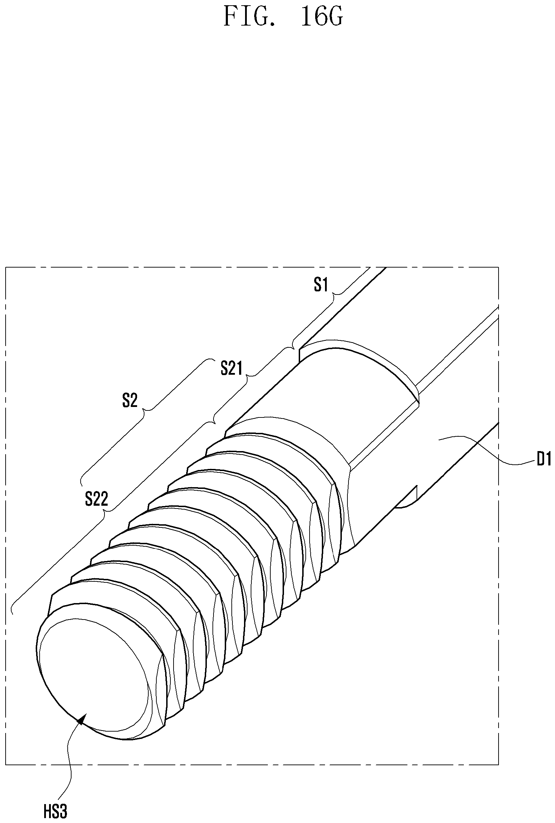

FIG. 16G is a partial perspective view of a shaft according to various embodiments of the disclosure.

With reference to FIG. 16G, in order to secure a hooking amount with the first opening (e.g., the first opening 4312a of FIG. 16B), the larger the size of the first protrusion (e.g., the first protrusion 4217a of FIG. 16B), the more advantageous it may be. In an embodiment, in order to secure the size of the first protrusion (e.g., the first protrusion 4217a of FIG. 16B), a portion of the first shaft HS3 may be formed to have a relatively small diameter. In an embodiment, the first shaft HS3 may include a first portion S1 and a second portion S2 formed to have a smaller diameter than that of the first portion S1. In an embodiment, the first portion S1 may support a first elastic member (e.g., the first elastic member CS3 of FIG. 16A) of the hinge device (e.g., the hinge device 420 of FIG. 16A), a first hinge arm (e.g., the first hinge arm 424 of FIG. 16A), or a cam element (e.g., the cam element 4291 of FIG. 16A). In an embodiment, the second portion may include a portion S21 for supporting the first rotation member and a portion S22 for supporting the first fixing member (e.g., the first fixing member N1 of FIG. 16A). In an embodiment, the second shaft (e.g., the second shaft HS4 of FIG. 16A) may also be formed in substantially the same manner as that of the first shaft HS3.

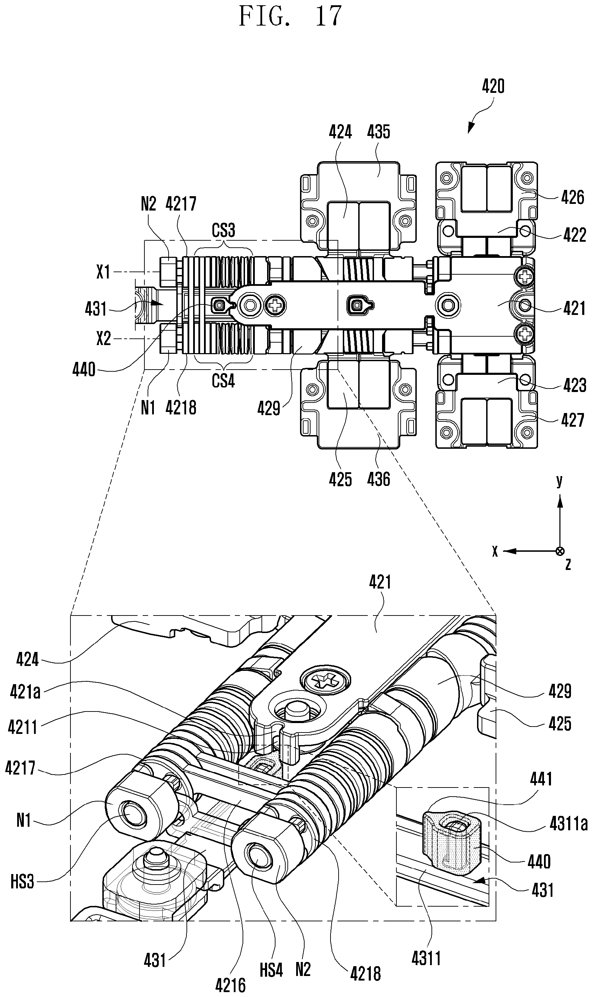

FIG. 17 is a diagram illustrating a coupling structure of a guide damper of a center plate and a hinge device according to various embodiments of the disclosure.

With reference to FIG. 17, the center plate 431 may include a plate portion 4311 having a length and a guide damper 440 protruded from the plate portion 4311. In an embodiment, the guide damper 440 may be disposed to be inserted into a mounting protrusion 4311a protruded from the center plate 431. In an embodiment, an end portion of the mounting protrusion 4311a is formed in a hook structure, thereby preventing the guide damper 440 from being separated from the mounting protrusion 4311a. In an embodiment, the guide damper 440 may include a protruding portion 441 protruded to be guided to the guide slit 421a formed in the support 421 of the hinge device 420. In an embodiment, the guide damper 440 may be made of an elastic material. In an embodiment, the guide damper 440 may be formed in substantially the same manner as that of the guide dampers 314 and 315 of FIGS. 8A to 8D.

According to various embodiments, in the case that the center plate 431 is disposed between a first support plate (e.g., the first support plate 311 of FIG. 3A) and a second support plate (e.g., the second support plate 312 of FIG. 3A), the protruding portion 441 of the guide damper 440 disposed to protrude from the center plate 431 may be guided by being received in a guide slit 421a formed in the support 421 of the hinge device 420. In an embodiment, as the center plate 431 advances in the -y axis direction toward the hinge device 420, the protruding portion 441 of the guide damper 440 may be received in the guide slit 421a of the support 421. At the same time, the first protrusion 4217a of the first rotation member 4217 may be disposed to penetrate the first opening 4312a of the center plate 431, and the second protrusion 4218a may be disposed to penetrate the second opening 4312b of the center plate 431. In an embodiment, in the case that the center plate 431 is completely coupled to the hinge device 420 and that the electronic device 100 is changed from the unfolded state to the folded state or from the folded state to the unfolded state, the center plate 431 may be reciprocated in a direction (e.g., ±z axis direction) perpendicular to the first rotation axis X1 and/or the second rotation axis X2. At the same time, the protruding portion 441 of the guide damper 440 may also be moved along the guide slit 421a of the support 421. In an embodiment, as the guide damper 440 and the protruding portion 441 are made of an elastic material, the guide damper 440 and the protruding portion 441 may help reduce an impact on peripheral parts due to distortion of the center plate 431 during an operation or an external impact after the guide damper 440 and the protruding portion 441 are received in the guide slit 421a.

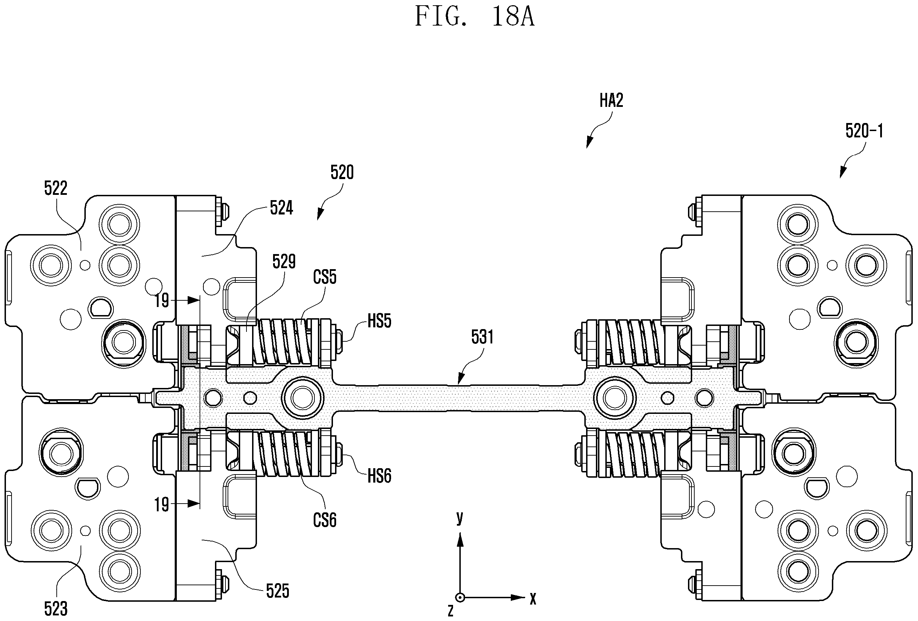

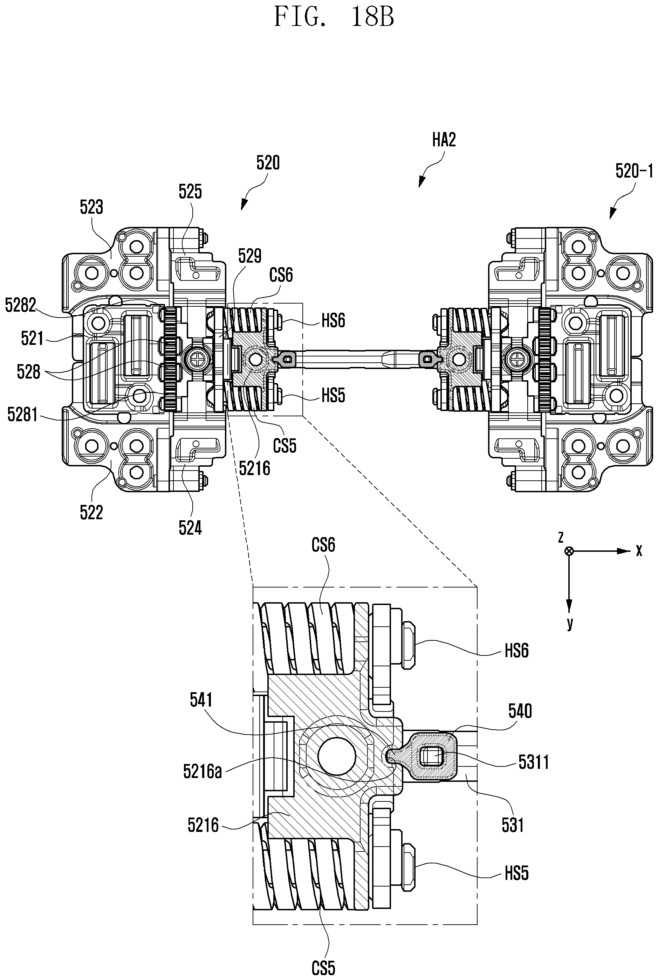

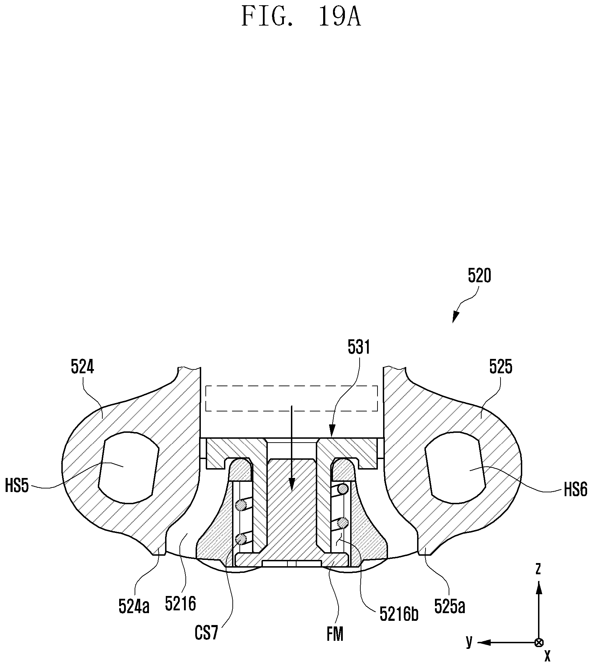

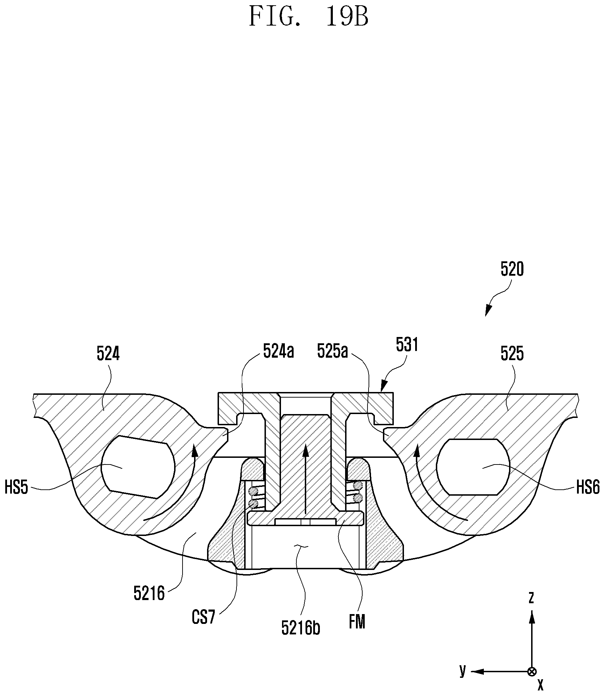

FIG. 18A is a diagram illustrating a constitution of a front surface of a hinge assembly according to various embodiments of the disclosure. FIG. 18B is a diagram illustrating a constitution of a rear surface of a hinge assembly according to various embodiments of the disclosure. FIGS. 19A and 19B are partial cross-sectional views of a hinge device in a folded state and an unfolded state of an electronic device viewed along line 19-19 of FIG. 18A according to various embodiments of the disclosure.

With reference to FIGS. 18A to 19B, a hinge assembly HA2 may include a first hinge device 520, a second hinge device 520-1 spaced apart from the first hinge device 520, and a center plate 531 disposed between the first hinge device 520 and the second hinge device 520-1 and movably disposed in a vertical direction (e.g., ±z axis direction) according to folding and unfolding motions of the first housing (e.g., the first housing 110 of FIG. 3A) and the second housing (e.g., the second housing 120 of FIG. 3A). In an embodiment, in an unfolded state of the electronic device (e.g., the electronic device 100 of FIG. 3A), the center plate 531 may be moved to form the same plane as that of the first support plate (e.g., the first support plate 311 of FIG. 3A) and the second support plate (e.g., the second support plate 312 of FIG. 3A).

Hereinafter, in describing the drawings, a structure in which the center plate 531 is coupled to the first hinge device 520 is illustrated and described, but a structure in which the center plate 531 and the second hinge device 520-1 are coupled may also have substantially the same constitution.

According to various embodiments, the hinge device 520 (e.g., the first hinge device 520 of FIG. 18A) may include a support 521 (e.g., rotator bracket or bracket) fixed to the hinge housing (e.g., the hinge housing 141 of FIG. 3A) through a fastening member such as a screw, a first shaft HS5 rotatably disposed in the support 521, and an second shaft HS6 rotatably disposed at the support 521 at a position spaced apart from the first shaft HS5. In an embodiment, the hinge device 520 may include a first rotator 522 (e.g., first hinge plate) rotatably coupled to the support 521 and a second rotator 523 (e.g., second hinge plate) rotatably coupled to the support 521. In an embodiment, the hinge device 520 may include a first hinge arm 524 disposed to rotate with the first shaft HS5, and a second hinge arm 525 disposed to rotate with the second shaft HS6. In an embodiment, the hinge device 520 may include a cam structure 529 disposed movably in an axial direction (e.g., ±x axis direction) so that the first shaft HS5 and the second shaft HS6 penetrate. In an embodiment, the cam structure 529 may be cam-coupled with the cam structure formed in the first hinge arm 524 and the second hinge arm 525. In an embodiment, the hinge device 520 may include a first elastic member CS5 and a second elastic member CS6 respectively disposed to press the cam structure 529 in a direction (e.g., -x axis direction) of the first hinge arm 524 and the second hinge arm 525 based on the shaft support 5216 in which the first shaft HS5 and the second shaft HS6 are disposed to penetrate. In an embodiment, the hinge device 520 may include a first gear 5281 disposed to rotate with the first shaft HS5, a second gear 5282 disposed to rotate with the second shaft HS6, and idle gears 528 gear-coupled with the first gear 5281 and the second gear 5282.

As illustrated in FIGS. 19A and 19B, at least a portion of the center plate 531 may penetrate a through hole 5216b formed in the shaft support 5216 and then be movably disposed in a vertical direction (e.g., ±z axis direction). In an embodiment, the hinge device 520 may include a fastening member FM received through the through hole 5216b and an elastic member CS7 disposed between the fastening member FM and the center plate 531. In an embodiment, the center plate 531 may be installed to be always pressed in a downward direction (e.g., -z axis direction) through the elastic member CS7 while being supported by the shaft support 5216. Accordingly, when the electronic device 100 is in a folded state, the center plate 531 may maintain a downwardly moved state in the downward direction (e.g., -z axis direction) by a pressing force of the elastic member CS7. In an embodiment, in the case that the electronic device 100 is changed from the folded state to the unfolded state, the center plate 531 may be moved upward in an upward direction (e.g., z-axis direction) by lifting a portion thereof through a first support protrusion 524a formed in the first hinge arm 524 and a second support protrusion 525a formed in the second hinge arm 525.

According to various embodiments, the center plate 531 may include a mounting protrusion 5311 protruded in a downward direction (e.g., -z axis direction). In an embodiment, the center plate 531 may include a guide damper 540 fixed through the mounting protrusion 5311 and made of an elastic material. In an embodiment, the guide damper 540 may include a protruding portion 541 protruded to be guided to a guide slit 5216a formed in the shaft support 5216 of the hinge device 520. In an embodiment, the guide damper 540 may be formed in substantially the same manner as that of the guide dampers 314 and 315 of FIGS. 8A to 8D. Accordingly, a guide coupling structure of the protruding portion 541 of the guide damper 540 and the guide slit 5216a of the shaft support 5216 may stably assist a movement to the vertical direction (e.g., ±z axis direction) of the center plate 531 when the electronic device 100 is operated.

According to various embodiments, the electronic device may include a foldable housing including a first housing (e.g., the first housing 110 of FIG. 3A), a second housing (e.g., the second housing 120 of FIG. 3A), and a hinge device (e.g., the hinge devices 320 and 320-1 of FIG. 3A) configured to rotatably connect the first housing and the second housing with respect to each other and to operate between a folded position, a partially folded position, and an unfolded position, wherein the hinge devices 320 and 320-1 may include a first shaft (e.g., the first shaft HS1 of FIG. 4) having a first rotation axis (e.g., the first rotation axis X1 of FIG. 4); and a second shaft (e.g., the second shaft HS2 of FIG. 4) having a second rotation axis (e.g., second rotation axis X2 of FIG. 4); a first support plate (e.g., the first support plate 311 of FIG. 3A) coupled to the hinge device in an area corresponding to the first housing; a second support plate (e.g., the second support plate 312 of FIG. 3A) coupled to the hinge device in an area corresponding to the second housing; a first rotation member (e.g., the first rotation member 3217 of FIG. 4) disposed to rotate with the first shaft and including a first protrusion (e.g., the first protrusion 3217a of FIG. 4) formed at a position spaced apart from the first rotation axis; a second rotation member (e.g., the second rotation member 3218a of FIG. 4) disposed to rotate with the second shaft and including a second protrusion (e.g., the second protrusion 3218a of FIG. 4) formed at a position spaced apart from the second rotation axis; and a center plate (e.g., the center plate 313 of FIG. 3A) including a first engaging portion (e.g., the first opening 3132a of FIG. 9A) disposed between the first support plate and the second support plate and interlocked with the first protrusion and a second engaging portion (e.g., the second opening 3132b of FIG. 9A) interlocked with the second protrusion, wherein the center plate may move downward from a first position to a second position through interlocking engagement of the first and second protrusions and the first and second engaging portions when the foldable housing is moved from the unfolded position to the folded position, and the center plate may move upward from a second position to a first position through interlocking engagement of the first and second protrusions and the first and second engaging portions when the foldable housing is moved from the folded position to the unfolded position.

According to various embodiments, the first engaging portion may be defined as a first opening, and the second engaging portion may be defined as a second opening, and the first opening and the second opening may be formed in a first bent region disposed at a first end portion of the center plate.

According to various embodiments, the first engaging portion may be defined as a first partial opening, and the second engaging portion may be defined as a second partial opening, and the first partial opening and the second partial opening may be formed in a first bent region disposed at a first end portion of the center plate.

According to various embodiments, the electronic device may include a flexible display (e.g., the flexible display 130 of FIG. 1A) disposed to be supported by the first and second housings, the first and second support plates, and the center plate.

According to various embodiments, the first protrusion may be disposed to penetrate the first opening, and the second protrusion may be disposed to penetrate the second opening.

According to various embodiments, the first opening may be formed to have an area larger than a cross-sectional area of the first protrusion, and the second opening may be formed to have an area larger than a cross-sectional area of the second protrusion.

According to various embodiments, the electronic device may include a gear support (e.g., the gear support 3215 of FIG. 4) in which the first shaft and the second shaft are disposed to penetrate together; a first hinge arm (e.g., the first hinge arm 324 of FIG. 4) fixed to rotate with the first shaft in a manner in which the first shaft penetrates and having a first cam element (e.g., the first cam element 3242 of FIG. 4); a second hinge arm (e.g., the second hinge arm 325 of FIG. 4) fixed to rotate with the second shaft in a manner in which the second shaft penetrates and having a second cam element (e.g., the second cam element 3252 of FIG. 4); a cam structure (e.g., the cam structure 329 of FIG. 4) including a third cam element (e.g., the third cam element 3291 of FIG. 4) cam-coupled with the first cam element in a manner in which the first shaft penetrates, and a fourth cam element (e.g., the fourth cam element 3292 of FIG. 4) cam-coupled with the second cam element in a manner that the second shaft penetrates; a shaft support (e.g., the shaft support 3216 of FIG. 4) in which the first shaft and the second shaft are disposed to penetrate together; and an elastic member (e.g., the elastic members CS1 and CS2 of FIG. 4) disposed between the shaft support and the cam structure.

According to various embodiments, the elastic member may include a first elastic member (e.g., the elastic member CS1 of FIG. 4) in which the first shaft is disposed to penetrate; and a second elastic member (e.g., the elastic member CS2 of FIG. 4) in which the second shaft is disposed to penetrate. The elastic member applies a linear force from the back to provide the force to the cam elements.

According to various embodiments, the cam structure may be disposed movably along a first rotation axis of the first shaft and a second rotation axis of the second shaft, and be disposed to be pressed in the direction of the first hinge arm and the second hinge arm through the elastic member.

According to various embodiments, the first rotation member may be disposed to contact the shaft support in a manner in which the first shaft penetrates, the second rotation member may be disposed to contact the shaft support in a manner in which the second shaft penetrates, and the shaft support may be disposed between the elastic member and the first and second rotation members.

According to various embodiments, the first rotation member and the second rotation member may be disposed to prevent separation in the direction of the first rotation axis and the second rotation axis through fixing members (e.g., the fixing members 3213-1 and 3213 of FIG. 4) fastened to each end portion of the first shaft and the second shaft.

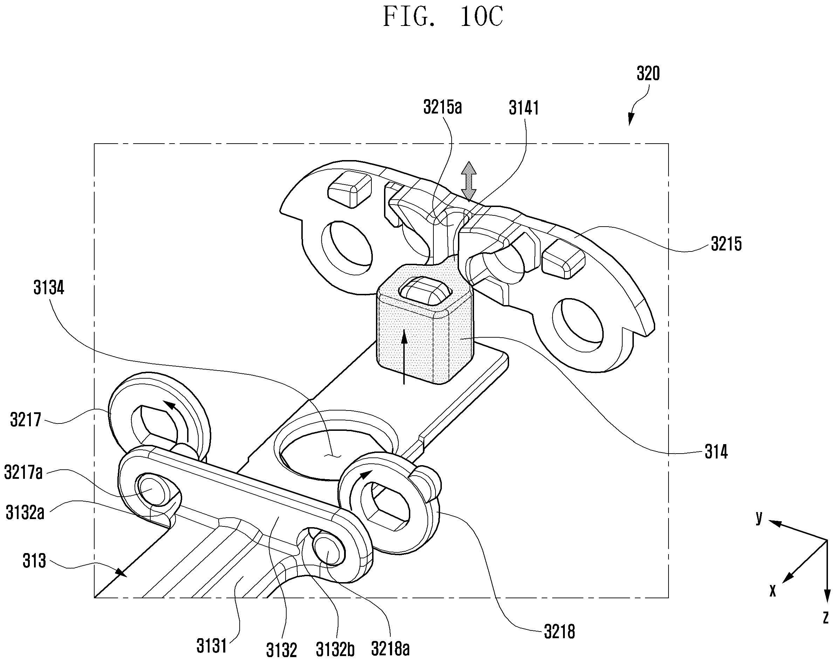

According to various embodiments, the electronic device may include a guide damper (e.g., the guide damper 314 of FIG. 10C) protruded from the center plate in the direction of the hinge device, wherein the guide damper may be guided along a moving direction of the center plate through a guide structure formed in at least a portion of the hinge device.

According to various embodiments, in the guide damper, an outwardly protruded protruding portion 3141 may be guided to a guide slit (e.g., the guide slit 3215a of FIG. 10C) formed in the gear support.

According to various embodiments, the guide damper (e.g., the guide damper 316 of FIG. 11C) may include a guide slit (e.g., the guide slit 3161 of FIG. 11C), and the guide damper may be guided in a manner in which the guide protrusion (e.g., the guide protrusion 3215b of FIG. 11C) formed in the gear support is received in the guide slit.

According to various embodiments, the guide structure may be formed in at least a portion of the support.

According to various embodiments, the guide damper may be made of an elastic material.

According to various embodiments, the electronic device may include a support (e.g., the support 321 of FIG. 4) configured to receive at least a portion of the first shaft and the second shaft, and the hinge device may include a first rotator (e.g., the first rotator 322 of FIG. 4) rotatably coupled to the support based on a third rotation axis (e.g., the third rotation axis X3 of FIG. 4), a second rotator (e.g., the second rotator 323 of FIG. 4) rotatably coupled to the support based on a fourth rotation axis (e.g., the fourth rotation axis X4 of FIG. 4), a first fixed body (e.g., the first fixed body 326 of FIG. 4) rotatably coupled to the first rotator based on a fifth rotation axis (e.g., the fifth rotation axis X5 of FIG. 4) and coupled to the first housing, and a second fixed body (e.g., the second fixed body 327 of FIG. 4) rotatably coupled to the second rotator based on a sixth rotation axis (e.g., the sixth rotation axis X6 of FIG. 4) and coupled to the second housing.

According to various embodiments, a foldable electronic device may include a housing including a first housing portion (e.g., the first housing 110 of FIG. 3A) and a second housing portion (e.g., the second housing 120 of FIG. 3A), a flexible display (e.g., the flexible display 130 of FIG. 1A) received in the first housing portion and the second housing portion, and a hinge assembly (e.g., the hinge assembly HA of FIG. 3A) configured to rotatably connect the first housing portion and the second housing portion to each other, wherein the hinge assembly may include a first shaft (e.g., the first shaft HS1 of FIG. 4) configured to rotate based on a first rotation axis (e.g., the first rotation axis X1 of FIG. 4) while the housing is folded, a second shaft (e.g., the second shaft HS2 of FIG. 4) configured to rotate based on a second rotation axis (e.g., the second rotation axis X2 of FIG. 4) while the housing is folded, a first rotation member (e.g., the first rotation member 3217 of FIG. 4) including a first protrusion (e.g., the first protrusion 3217a of FIG. 4) connected to the first shaft so as to rotate with the first shaft and spaced apart from the first rotation axis by a designated distance, a second rotation member (e.g., the second rotation member 3218 of FIG. 4) including a second protrusion (e.g., the second protrusion 3218a of FIG. 4) connected to the second shaft so as to rotate with the second shaft and spaced apart from the second rotation axis by a designated distance, and a center plate (e.g., the center plate 313 of FIG. 8B) to which a guide portion (e.g., the guide portion 3132 of FIG. 8B) including a first opening (e.g., the first opening 3132a of FIG. 8B) corresponding to the first protrusion and a second opening (e.g., the second opening 3132b of FIG. 8B) corresponding to the second protrusion is connected, wherein the center plate may be moved to a position supporting at least a portion of the flexible display in a fully unfolded state of the foldable electronic device through an interlocking structure of the protrusions and the openings, and the center plate may be moved to a position that does not support at least a portion of the flexible display in a fully folded state of the foldable electronic device through an interlocking structure of the protrusions and the openings.

According to various embodiments, when the first rotation member is rotated, the first protrusion may perform a circular motion around the first rotation axis, and at least one of a designated distance and a size of the first protrusion moves, or a rotation angle of the first protrusion performing a circular motion may be proportional to a movement distance of the center plate.

According to various embodiments, the guide portion may be positioned perpendicular to the center plate, an upper surface of the guide portion may be formed to be positioned at substantially the same surface as an upper surface of the center plate, and a lower surface of the guide portion may be formed to be positioned to protrude further than a lower surface of the center plate.

According to various embodiments, the first opening and the second opening may be disposed so that an imaginary line (the imaginary line IL of FIG. 8B) connecting the center of the first opening and the center of the second opening is not positioned between the upper surface and the lower surface of the center plate.

According to various embodiments, the first opening and the second opening may be formed in a shape in which a horizontal length (e.g., the second length L2 of FIG. 14) is larger than a vertical length (e.g., the first length L1 of FIG. 14).

According to various embodiments, the first protrusion may move in contact with an upper surface of the first opening while the foldable device is unfolded, and move in contact with a lower surface of the first opening while the foldable device is folded.

According to various embodiments, the hinge assembly may further include a shaft support (e.g., the shaft support 3216 of FIG. 4) through which the first shaft and the second shaft penetrate together and a first separation prevention part (e.g., the fixing member 3213-1 of FIG. 4) positioned at the end of the first shaft to prevent the first rotation member from separating.

According to various embodiments, the first rotation member may be disposed between the shaft support and the first separation prevention part.

According to various embodiments, the hinge assembly may further include a shaft support (e.g., the gear support 3216 of FIG. 10C) through which the first shaft and the second shaft penetrate together, and a guide damper (e.g., the guide damper 314 of FIG. 10C) having a protruding protrusion (e.g., the protruding portion 3141 of FIG. 10C) protruded in a longitudinal direction of the center plate in the center plate, and the guide damper may be guided in a moving direction of the center plate along a guide slit (e.g., the guide slit 3215a of FIG. 10C) in which the protruding portion is formed in the shaft support.

According to various embodiments, a length of the protruding portion may be longer than that of the guide slit.

According to various embodiments, the guide damper may be made of an elastic material.

According to various embodiments, the first protrusion (e.g., the first protrusion 3217a of FIG. 4) and/or the second protrusion (e.g., the second protrusion 3218a of FIG. 4) may include an elastic material. For example, the first protrusion (e.g., the first protrusion 3217a of FIG. 4) and/or the second protrusion (e.g., the second protrusion 3218a of FIG. 4) may be made of a metal and be formed with at least partially covered with an elastic material (e.g., polymer material, rubber, urethane foam, and/or silicone). For example, the first protrusion (e.g., the first protrusion 3217a of FIG. 4) and/or the second protrusion (e.g., the second protrusion 3218a of FIG. 4) may be of a metal and be formed in a manner in which an elastic material is at least partially coated on the outer surface thereof.

According to various embodiments, the first opening 3132a and/or the second opening 3132b of the first guide portion 3132, and the third opening 3133a and/or the fourth opening 3133b of the second guide portion 3133 may include an elastic material. For example, the first guide portion 3132 and the second guide portion 3133 of the center plate 313 may be made of a metal, and the first opening 3132a and/or the second opening 3132b of the first guide portion 3132 and the third opening 3133a and/or the fourth opening 3133b of the second guide portion 3133 may be formed with at least partially covered with an elastic material (e.g., polymer material, rubber, urethane foam, rubber, and/or silicone).

Embodiments of the disclosure disclosed in this specification and drawings merely present specific examples to easily describe the technical content according to the embodiments of the disclosure and to help the understanding of the embodiments of the disclosure, and they do not intend to limit the scope of the embodiments of the disclosure. Accordingly, in addition to the embodiments disclosed herein, all changes or modifications derived from the technical ideas of various embodiments of the disclosure should be interpreted as being included in the scope of various embodiments of the disclosure.

## Claims

1. An electronic device, comprising:
a foldable housing including a first housing (110), a second housing (120), and at least one hinge device(320, 320-1) configured to rotatably connect the first housing (110) and the second housing (120) and to operate between a folded position, a partially folded position, and an unfolded position,
wherein the at least one hinge device(320, 320-1) comprises:
a first shaft (HS1) having a first rotation axis (X1); and
a second shaft (HS2) having a second rotation axis (X2);
a first support plate (311) coupled to the at least one hinge device (320, 320-1) in an area corresponding to the first housing (110);
a second support plate (312) coupled to the at least one hinge device (320, 320-1) in an area corresponding to the second housing (120);
a first rotation member (3217) disposed to rotate with the first shaft (HS1) and including a first protrusion (3217a) formed at a position spaced apart from the first rotation axis (X1);
a second rotation member (3218) disposed to rotate with the second shaft (HS2) and including a second protrusion (3218a) formed at a position spaced apart from the second rotation axis (X2); and
a center plate (313) including:
a first engaging portion (3132a) disposed between the first support plate (311) and the second support plate (312) and interlocked with the first protrusion (3217a); and
a second engaging portion (3132b) interlocked with the second protrusion (3218a),
wherein the center plate (313) is configured to move downward from a first position to a second position through interlocking engagement of the first protrusion (3217a) and the first engaging portion (3132a), and the second protrusion (3218a)and the second engaging portion (3132b) when the foldable housing is moved from the unfolded position to the folded position, and
the center plate (313) is configured to move upward from a second position to a first position through interlocking engagement of the first protrusion (3217a) and the first engaging portion (3132a), and the second protrusion (3218a)and the second engaging portion (3132b) when the foldable housing is moved from the folded position to the unfolded position.

2. The electronic device of claim 1, wherein the first engaging portion (3132a) is defined as a first opening, and the second engaging portion (3132b) is defined as a second opening, and
the first opening and the second opening are formed in a first bent region disposed at a first end portion of the center plate (313).

3. The electronic device of claim 1, wherein the first engaging portion (3132a) is defined as a first partial opening, and the second engaging portion (3132b) is defined as a second partial opening, and
the first partial opening and the second partial opening are formed in a first bent region disposed at a first end portion of the center plate (313).

4. The electronic device of any one of claims 1 to 3, further comprising a flexible display (130) disposed to be supported by the first housing (110),the second housing (120), the first support plate (311),the second support plate (312), and the center plate (313).

5. The electronic device of claim 2, wherein the first protrusion (3217a) is disposed to penetrate the first opening, and the second protrusion (3218a) is disposed to penetrate the second opening.

6. The electronic device of any one of claims 2or 5, whereinthe first opening is formed to have an area larger than a cross-sectional area of the first protrusion (3217a), and
the second opening is formed to have an area larger than a cross-sectional area of the second protrusion (3218a).

7. The electronic device of any one of claims 1 to 6, further comprising:
a gear support (3215) in which the first shaft (HS1) and the second shaft (HS2) are disposed to penetrate together;
a first hinge arm (324) fixed to rotate with the first shaft (HS1) in a manner in which the first shaft (HS1) penetrates and having a first cam element(3242);
a second hinge arm (325) fixed to rotate with the second shaft (HS2) in a manner in which the second shaft (HS2) penetrates and having a second cam element(3252);
a cam structure (329) including a third cam element(3291) cam-coupled with the first cam element(3242) in a manner in which the first shaft (HS1) penetrates, and a fourth cam element(3292) cam-coupled with the second cam element(3252) in a manner that the second shaft (HS2) penetrates;
a shaft support (3216) in which the first shaft (HS1) and the second shaft (HS2) are disposed to penetrate together; and
an elastic member(CS1, CS2) disposed between the shaft support(3216) and the cam structure(329).

8. The electronic device of claim 7, whereinthe elastic member (CS1, CS2) comprises:
a first elastic member (CS1) in which the first shaft (HS1) is disposed to penetrate; and
a second elastic member (CS2) in which the second shaft (HS2) is disposed to penetrate.

9. The electronic device of claim 7 or 8, wherein the cam structure(329) is disposed movably along thefirst rotation axis (X1) of the first shaft (HS1) and the second rotation axis (X2) of the second shaft (HS2), and is disposed to be pressed in the direction of the first hinge arm (324) and the second hinge arm (325) through the elastic member(CS 1, CS2).

10. The electronic device of any one of claims 7 to 9, whereinthe first rotation member (3217) is disposed to contact the shaft support (3216) in a manner in which the first shaft (HS 1) penetrates,
the second rotation member (3218) is disposed to contact the shaft support (3216) in a manner in which the second shaft (HS2) penetrates, and
the shaft support (3216) is disposed between the elastic member(CS1, CS2) and the first and second rotation members (3217, 3218).

11. The electronic device of any one of claims 7 to 10, wherein the first rotation member (3217) and the second rotation member (3218) are disposed to prevent separation in the direction of the first rotation axis (X1) and the second rotation axis (X2) through fixing members (3213-1, 3213-2) fastened to each end portion of the first shaft (HS1) and the second shaft (HS2).

12. The electronic device of any one of claims 7 to 11, further comprising a guide damper (314, 315, 316, 317) protruded from the center plate (313) in the direction of the at least one hinge device (320, 320-1),
wherein the guide damper (314, 315, 316, 317) is guidable along a moving direction of the center plate (313) through a guide structure formed in at least a portion of the at least one hinge device (320, 320-1).

13. The electronic device of claim 12, wherein in the guide damper (314), an outwardly protruded protruding portion (3141) is guidable to a guide slit (3215a) formed in the gear support (3215).

14. The electronic device of claim 12, wherein the guide damper (316) comprises a guide slit (3161), and is guidable in a manner in which a protrusion (3215b) formed in the gear support (3215) is received in the guide slit (3161).

15. The electronic device of claim 12, wherein the guide structure is formed in at least a portion of the support.
